# EUROPEAN PATENT APPLICATION

(11) **EP 4 826 491 A2**
(43) Date of publication of application: **21.10.2026**
(21) Application number: 26173015.4
(22) Date of filing: 17.04.2026
(51) Int. Cl.: G06F 1/20

(54) **SPLIT HEAT SINK COOLING SYSTEM FOR ENHANCED SERVICEABILITY**

(30) Priority: 17.04.2025 US 202563790302 P; 29.08.2025 US 202519314081; 04.04.2026 US 202619639151
(71) Applicant: Nvidia Corporation, Santa Clara, CA 95051 (US)
(72) Inventor: GITE, Jay, Santa Clara, 95051 (US)
(74) Representative: Mathys & Squire

(57) **Abstract**

A heat sink comprises a first section to extract heat generated by a high-power component, and at least a second section, attachable to and detachable from the first section, to extract heat generated by a low-power component. The at least a second section, when attached to the first section, is thermally coupled to the first section such that the heat generated by the high-power component is further dissipated by the at least a second section. The heat sink may correspond to an air-cooled or liquid-cooled heat sink. When liquid-cooled, the heat sink may include cold plates, fluid flow channels, or the like.

## Description

### CROSS-REFERENCE TO RELATED APPLICATION

The present application is a continuation-in-part of U.S. Application No. 19/314,081, filed on August 29, 2025, entitled "SPLIT HEAT SINK COOLING SYSTEM FOR ENHANCED SERVICEABILITY", which claims the benefit of and priority under 35 U.S.C. § 119 to U.S. Provisional Application Serial No. 63/790,302, filed April 17, 2025, entitled "SPLIT HEAT SINK" the entire disclosures of which are hereby incorporated herein by reference, in their entireties, for all that they teach and for all purposes.

### FIELD OF THE DISCLOSURE

Embodiments of the present disclosure relate generally to thermal solutions for computing hardware, and more specifically to cooling components used in a datacenter.

### BACKGROUND

As datacenters continue to operate at higher speeds (e.g., 100Gb and beyond) and semiconductor dies grow larger in response to increased processing requirements, the thermal demands on the datacenter components increase as well. Heat generation in datacenters occurs primarily due to the electricity used by servers, storage devices, and other hardware components, where nearly all the consumed energy is converted into heat as a byproduct of processing data, essentially meaning that for every watt of electricity used, a watt of heat is produced. The heat requires careful management; otherwise, components of the datacenter may fail under extreme thermal loads. For instance, processing units can generate heat during operation, which can result in reduced processing power and, in some cases, the failure of those processing units as well as the failure of system components connected thereto.

### GENERAL DESCRIPTION

The invention is defined by the claims. In order to illustrate the invention, aspects and embodiments which may or may not fall within the scope of the claims are described herein.

As the data center infrastructure evolves, enhanced serviceability for the servers within a data center becomes more important. It is particularly important to address the challenges of assembly and disassembly required for servicing critical components on the baseboard. In a server baseboard, the components under the heat sink are often difficult to service as it may be necessary to remove the entire heat sink every time they are accessed. This problem is especially apparent when high-power components like a Graphics Processing Unit (GPU) or Central Processing Unit (CPU) are utilized. (The same is true of central processing unit (CPU) packages, parallel processing unit (PPU) packages, quantum processing unit (QPU) packages, and other processing unit packages. Throughout the present disclosure, it should be understood that references to CPUs, CPU packages, GPUs, and GPU packages apply also to other types of processing units and processing unit packages, respectively, including any other type of processing unit and processing unit package described herein.) Specifically, cooling these high-power components may require a relatively large surface for the heat sink. As a result, attaining a desired level of cooling may require using a large heat sink that blocks off a significant part of the board and prevents pluggable components from direct service.

One area where this problem is particularly apparent is for servicing the memory modules around the processing unit (e.g., GPU and/or CPU). A memory module (e.g., a Small Outline Compression Attached Memory Module (SOCAMM), a Dual In-Line Memory Module (DIMM), a network module, an optical module, a re-timer, and an Mid-Board Optical Module (MBOM)) may be a pluggable component but the heat sink of the processing unit may cover the memory modules, which means that the larger heat sink of the processing unit needs to be removed every time access to the memory module is desired. This configuration of components makes it extremely difficult to service the memory modules in the field.

Embodiments of the present disclosure provide an approach to address the above-noted issues. One aspect of the present disclosure is to provide a split heat sink. In some embodiments, the heat sink is split into mechanically separate but thermally connected pieces, thereby providing a solution that is capable of conducting heat fairly between the individual pieces. The proposed approach provides a substantially uniform air temperature downstream of the heat sink avoiding large temperature gradients (e.g., minimizing temperature gradients below at least 5 degrees Celsius across the area being cooled) and enabling sensitive components downstream to operate effectively. Because of this conduction path, the individual pieces come together thermally and act as a single body from a heat transfer perspective although they can be assembled and disassembled separately. Aspects of the proposed solution thereby provide for relatively easy serviceability while also providing effective heat transfer capabilities. In other words, it becomes possible to service a pluggable component (e.g., a memory module) by simply removing a piece of the heat sink from the other piece or pieces of the heat sink without requiring disassembly of the other piece or pieces of the heat sink.

Aspects of the present disclosure include the ability to: enable effective cooling of high-power components (e.g., GPUs and/or CPUs) even after splitting the heat sink into multiple pieces which are independently serviceable; provide a way to have separate heat sinks for individual components yet cool them effectively; and enable extremely simple serviceability of pluggable components (e.g., a memory module) by simply removing a piece of the heat sink from the other pieces of the heat sink without requiring disassembly of the other pieces of the heat sink.

The present disclosure provides several advantages. First, in embodiments of the present disclosure a thermal connection is provided between heat sink parts, thus a heat transfer path between the individual heat sink pieces is provided that is not available in prior solutions. Second, embodiments of the present disclosure enable improved serviceability, including for pluggable components neighboring a processing unit and/or processing unit package. Third, embodiments of the present disclosure provide substantially uniform air temperature downstream of the high-power component (e.g., processing unit) and low-power components (e.g., SOCAMM, DIMM, network module, optical module, re-timer, MBOM). Fourth, embodiments of the present disclosure demonstrate a lower localized pressure drop since the fin pitch does not need to be aggressive to achieve efficient heat transfer. As a non-limiting example, the fin pitch may be at least 1.4mm. Fifth, embodiments of the present disclosure exhibit a lower system pressure drop and have reduced complexity since ducting is not a requirement of the system to direct airflow towards the heat sink of the high-power component (e.g., processing unit). As a non-limiting example, the thermally-coupled heat sink sections may demonstrate a localized pressure drop of not more than 1.1psi at 100cfm without departing from the scope of the present disclosure. In some embodiments, the thermally-coupled heat sink sections may demonstrate a substantially constant pressure drop across their collective surfaces.

A heat sink according to embodiments of the present disclosure may comprise a first section to extract heat generated by a high-power component, and at least a second section, attachable to and detachable from the first section, to extract heat generated by a low-power component. The at least a second section, when attached to the first section, is thermally coupled to the first section such that the heat generated by the high-power component is further dissipated by the at least a second section.

A system according to other embodiments of the present disclosure may comprise a processing unit; a first memory module; a first heat sink section to extract heat generated by the processing unit; and a second heat sink section to extract heat generated by the first memory module, wherein the second heat sink section is attachable to and detachable from the first heat sink section, and wherein the first and second heat sink sections, when attached, collectively transfer heat from the processing unit.

A split heat sink according to still other embodiments of the present disclosure may be or comprise a central heat sink configured to extract heat generated by a processing unit; and a first side wing heat sink configured to extract heat generated by a memory module, the first side wing heat sink comprising at least one heat pipe and at least one fin; wherein the first side wing heat sink is removably attachable to the central heat sink and configured to also extract a portion of the heat generated by the processing unit when attached to the central heat sink. It should be appreciated that the side wing heat sink may take the form of a finless thermal spreader in some embodiments, such as liquid-cooled embodiments.

In some embodiments, a heat sink is provided that includes: a first section to extract heat generated by a high-power component; and at least a second section, attachable to and detachable from the first section, to extract heat generated by a low-power component, wherein the at least a second section, when attached to the first section, is thermally coupled to the first section such that the heat generated by the high-power component is further dissipated by the at least a second section.

In some aspects, the high-power component includes at least one of a Graphics Processing Unit (GPU) and Central Processing Unit (CPU).

In some aspects, the low-power component includes a pluggable module. As an example, the memory module comprises at least one of a Small Outline Compression Attached Memory Module (SOCAMM), a Dual In-Line Memory Module (DIMM), a network module, an optical module, a re-timer, and an Mid-Board Optical Module (MBOM).

In some aspects, the low-power component is serviceable without detaching the high-power component from the first section.

In some aspects, the first section is attached to the at least a second section with one or more screws.

In some aspects, the at least a second section accommodates one or more heat pipes. As an example, the one or more heat pipes are thermally coupled with the first section and conduct heat from the first section into the at least a second section.

In some aspects, the first section and the at least a second section both include one or more finned structures.

In some aspects, the at least a second section includes a second section thermally coupled with a first low-power component and a third section thermally coupled with a second low-power component. In some aspects, the first section is positioned between the second section and the third section.

In some aspects, a flow channel to carry a cooling fluid is provided between the first section and the high-power component.

In some aspects, the first section includes a cold plate assembly having a cold plate body, a cold plate cover, and a cold plate thermal contact, where the cold plate body is positioned between the cold plate cover and the cold plate thermal contact, and where the flow channel passes between the cold plate body and the cold plate thermal contact to allow heat generated by the high-power component to be transferred to the cooling fluid via the cold plate thermal contact.

In some aspects, the cold plate thermal contact includes a plurality of fins and the cooling fluid flows across the plurality of fins.

In some embodiments, a system is provided that includes: a processing unit; a first memory module; a first heat sink section to extract heat generated by the processing unit; and a second heat sink section to extract heat generated by the first memory module, where the second heat sink section is attachable to and detachable from the first heat sink section, and where the first and second heat sink sections, when attached, collectively transfer heat from the processing unit.

In some aspects the system may further include a Printed Circuit Board (PCB) that is attached to both the processing unit and the first memory module. In some aspects, the PCB carries electrical signals between the processing unit and the first memory module.

In some aspects the system may further include: a second memory module; and a third heat sink section to extract heat generated by the second memory module, where the third heat sink section is attachable to and detachable from the first heat sink section, and where the first and third heat sink sections, when attached, collectively transfer heat from the processing unit.

In some aspects, the first memory module is serviceable by detaching the first heat sink section from the second heat sink section.

In some aspects, the first heat sink section is attached to the second heat sink section with one or more screws.

In some aspects, the first heat sink section and the second heat sink section comprise a thermally-conductive material that includes at least one of: copper, aluminum, and an alloy thereof.

In some aspects the system further includes one or more heat pipes. In some aspects, the one or more heat pipes are embedded in a base of the second heat sink section. In some aspects, the first heat sink section includes a vapor chamber and the one or more heat pipes that are embedded in the base of the second heat sink section abut the vapor chamber of the first heat sink section.

In some aspects, the first heat sink section and the second heat sink section, when attached, substantially uniformly distribute heat generated by the processing unit and the memory module.

In some aspects, the processing unit includes at least one of a Graphics Processing Unit (GPU) and a Central Processing Unit (CPU).

In some aspects, the first memory module comprises at least one of a Small Outline Compression Attached Memory Module (SOCAMM), a Dual In-Line Memory Module (DIMM), a network module, an optical module, a re-timer, and an Mid-Board Optical Module (MBOM).

In some aspects the system may further include a stiffener base that provides structural support for the first heat sink section and that provides a connection interface between the first heat sink section and the second heat sink section.

In some aspects the system may further include a Thermal Interface Material (TIM). In some aspects, the TIM is provided between the stiffener base and the second heat sink section. In some aspects, the TIM is provided between the second heat sink section and the first memory module. In some aspects, the TIM includes at least one of a grease, a gap pad, a phase change material, and a putty, and wherein the TIM provides a substantially uniform cooling between the stiffener base, the first heat sink, and/or the second heat sink. In some aspects, the TIM accommodates a tolerance difference between the stiffener base, the first heat sink section, the second heat sink section, the processing unit, and/or the memory module. Non-limiting examples of materials that may be used in the TIM include base materials (e.g., silicone elastomers, acrylics, epoxies, and/or thermoplastics), conductive fillers (e.g., aluminum oxide, boron nitride, zinc oxide, graphite, graphene, and/or other polymers to enhance conductivity), combinations thereof, and the like.

In some aspects, the system further includes: a fluid inlet; a fluid outlet; an inlet tube that carries a cooling fluid between the fluid inlet and the first heat sink section; and a flow channel contained within the first heat sink section, where the cooling fluid flows through the flow channel to extract the heat generated by the processing unit.

In some aspects, the first heat sink section is liquid-cooled.

In some aspects, the first heat sink section is air-cooled.

In some embodiments, a split heat sink assembly is provided that includes: a central heat sink configured to extract heat generated by a processing unit; and a first side wing heat sink configured to extract heat generated by a memory module, the first side wing heat sink comprising at least one heat pipe and at least one fin; where the first side wing heat sink is removably attachable to the central heat sink and configured to also extract a portion of the heat generated by the processing unit when attached to the central heat sink.

In some aspects the split heat sink assembly further includes: a plurality of heat sink sections, each one of the heat sink sections mechanically connected to at least another one of the plurality of heat sink sections, where at least one of the plurality of heat sink sections is removable from the split heat sink assembly to facilitate access to an adjacent one of the plurality of heat sink sections.

In some aspects, the plurality of heat sink sections are thermally coupled so as to act as a single thermal unit.

In some aspects, the thermally coupled heat sink sections cause substantially uniform heating of surrounding air, such that air downstream of the thermally coupled heat sink sections has a substantially uniform air temperature.

In some aspects, heat transferred from the thermally coupled heat sink sections does not prevent sensitive components downstream of the thermally coupled heat sink sections from operating effectively.

In some aspects, removal of the at least one of the plurality of heat sink sections does not prevent the remaining ones of the plurality of heat sink sections from operating as a single thermal unit.

In some aspects, the thermally coupled heat sink sections include a plurality of finned structures having a fin pitch of at least 1.4mm.

In some aspects, the thermally coupled heat sink sections demonstrate a localized pressure drop of not more than 1.1psi at 100cfm.

In some aspects, operation of the split heat sink assembly does not require ducting to achieve sufficient airflow through the plurality of finned structures.

In some aspects, the thermally coupled heat sink sections provide a substantially constant pressure drop
In some aspects, one of the plurality of heat sink sections is a central heat sink.

In some aspects, the central heat sink includes a vapor chamber configured to be in thermal communication with a processing unit or processing unit package.

In some aspects, the central heat sink comprises a vapor chamber configured to be in thermal communication with a high-powered component when in use.

In some embodiments, a system is provided that includes: a first split heat sink assembly, including: a first central heat sink that is liquid-cooled; and at least one side wing heat sink that is thermally coupled with the first central heat sink; and a second split heat sink assembly, comprising: a second central heat sink that is liquid-cooled; and at least one additional side wing heat sink that is thermally coupled with the second central heat sink.

In some aspects, the first central heat sink is connected with the at least one side wing heat sink with at least a first screw, wherein the second central heat sink is connected with the at least one additional side wing heat sink with at least a second screw, wherein the at least one side wing heat sink is attachable to and detachable from the first central heat sink, and wherein the at least one additional side wing heat sink is attachable to and detachable from the second central heat sink.

In some aspects, the first central heat sink is coupled with the second central heat sink by a coupling tube that carries a cooling fluid therebetween.

In some aspects, the at least one side wing heat sink is thermally coupled with the first central heat sink by at least a first heat pipe and where the at least one additional side wing heat sink is thermally coupled with the second central heat sink by at least a second heat pipe.

In some aspects, the first central heat sink extracts heat generated by a first high-power component, where the second central heat sink extracts heat generated by a second high-power component, where the at least one side wing heat sink extracts heat generated by a first low-power component, where the at least one additional side wing heat sink extracts heat generated by a second low-power component, and where a cooling fluid follows a flow path that causes the cooling fluid to encounter the first and second low-power components before encountering the first and second high-power components so as to avoid damaging the first and second low-power components with the heat generated by the first and second high-power components.

In some aspects, the cooling fluid follows a fluid flow path having at least one set of parallel flow channels.

Embodiments of the present disclosure also contemplate a method of servicing a computing system, the method including: removing at least one fastener that couples a side wing heat sink to a central heat sink; sliding the side wing heat sink in at least a first direction relative to the central heat sink while the central heat sink maintains a fluidic connection with a source of a cooling fluid; and enabling access to a component cooled by the side wing heat sink while the fluidic connection is maintained.

Any aspect in combination with any one or more other aspects.

Any one or more of the features disclosed herein.

Any one or more of the features as substantially disclosed herein.

Any one or more of the features as substantially disclosed herein in combination with any one or more other features as substantially disclosed herein.

Any one of the aspects/features/implementations in combination with any one or more other aspects/features/implementations.

Use of any one or more of the aspects or features as disclosed herein.

It is to be appreciated that any feature described herein can be claimed in combination with any other feature(s) as described herein, regardless of whether the features come from the same described implementation.

The details of one or more aspects of the disclosure are set forth in the accompanying drawings and the description below. Other features, objects, and advantages of the techniques described in this disclosure will be apparent from the description and drawings, and from the claims.

Numerous additional features and advantages of the present disclosure will become apparent to those skilled in the art upon consideration of the implementation descriptions provided hereinbelow.

A heat sink comprises a first section to extract heat generated by a high-power component, and at least a second section, attachable to and detachable from the first section, to extract heat generated by a low-power component. The at least a second section, when attached to the first section, is thermally coupled to the first section such that the heat generated by the high-power component is further dissipated by the at least a second section. The heat sink may correspond to an air-cooled or liquid-cooled heat sink. When liquid-cooled, the heat sink may include cold plates, fluid flow channels, or the like.

Any feature of one aspect or embodiment may be applied to other aspects or embodiments, in any appropriate combination. In particular, any feature of a method aspect or embodiment may be applied to an apparatus aspect or embodiment, and vice versa.

Additional features and advantages are described herein and will be apparent from the following Description and the figures.

### BRIEF DESCRIPTION OF THE SEVERAL VIEWS OF THE DRAWINGS

Having thus described the disclosure in general terms, reference will now be made to the accompanying drawings, which are not necessarily drawn to scale:
Fig. 1A is a top perspective view of a split heat sink according to at least some embodiments of the present disclosure;
Fig. 1B is a block diagram of a split heat sink according to at least some embodiments of the present disclosure;
Fig. 2A is a side elevation view of a split heat sink according to at least some embodiments of the present disclosure, showing two side wing heat sinks separated from a central heat sink;
Fig. 2B is a bottom plan view of a split heat sink according to at least some embodiments of the present disclosure, showing two side wing heat sinks separated from a central heat sink;
Fig. 3A is a bottom plan view of a split heat sink according to at least some embodiments of the present disclosure, with one or more components removed to show details of the split heat sink;
Fig. 3B is a bottom plan view of a split heat sink according to at least some embodiments of the present disclosure, with one or more components removed to show details of the split heat sink;
Fig. 4 is a bottom perspective view of a split heat sink according to at least some embodiments of the present disclosure, with one or more components removed to show details of the split heat sink;
Fig. 5A is a top perspective view of two side wing heat sinks of a split heat sink according to at least some embodiments of the present disclosure;
Fig. 5B is a top perspective view of a central heat sink of a split heat sink according to at least some embodiments of the present disclosure;
Fig. 6 is a bottom perspective view of a heat pipe arrangement for a split heat sink according to at least some embodiments of the present disclosure;
Fig. 7 is a bottom perspective view of components of a split heat sink according to at least some embodiments of the present disclosure;
Fig. 8 is a side plan view of a split heat sink operably connected to a CPU and a plurality of memories according to at least some embodiments of the present disclosure;
Fig. 9 is a series of heat maps showing heat transfer results achieved using two different configurations of a split heat sink according to at least some embodiments of the present disclosure;
Fig. 10 is a block diagram illustrating a computer system according to at least some embodiments of the present disclosure;
Fig. 11 depicts a datacenter according to at least some embodiments of the present disclosure;
Fig. 12 depicts a block diagram of a system according to at least some embodiments of the present disclosure;
Fig. 13 depicts a block diagram of a computing environment according to at least some embodiments of the present disclosure.
Fig. 14 is an isometric top view of an alternative configuration of a system according to at least some embodiments of the present disclosure;
Fig. 15 is a second isometric view of the system illustrated in Fig. 14;
Fig. 16 is a cross-sectional side view showing a fluid flow through a liquid-cooled system according to at least some embodiments of the present disclosure;
Fig. 17 is an isometric view of a split heat sink assembly according to at least some embodiments of the present disclosure;
Fig. 18A is an isometric view of a cold plate thermal contact according to at least some embodiments of the present disclosure;
Fig. 18B is a side view of the cold plate thermal contact according to at least some embodiments of the present disclosure;
Fig. 19A is a first top isometric view of a cold plate body according to at least some embodiments of the present disclosure;
Fig. 19B is a second top isometric view of the cold plate body according to at least some embodiments of the present disclosure;
Fig. 20A is a first bottom isometric view of the cold plate body and cold plate thermal contact according to at least some embodiments of the present disclosure;
Fig. 20B is a second bottom isometric view of the cold plate body with the cold plate thermal contact removed therefrom according to at least some embodiments of the present disclosure;
Fig. 21 is an isometric view of a side wing heat sink according to at least some embodiments of the present disclosure;
Fig. 22 is an isometric view of first and second central heat sink sections according to at least some embodiments of the present disclosure;
Fig. 23A is a top isometric view of a cold plate cover according to at least some embodiments of the present disclosure;
Fig. 23B is a bottom isometric view of a cold plate cover according to at least some embodiments of the present disclosure;
Fig. 23C is a side view of the cold plate cover according to at least some embodiments of the present disclosure;
Fig. 23D is a top view of the cold plate cover according to at least some embodiments of the present disclosure;
Fig. 24 is an exploded view of a cold plate assembly according to at least some embodiments of the present disclosure; and
Fig. 25 is a flow diagram illustrating an example method according to at least some embodiments of the present disclosure.

Like reference numbers and designations in the various drawings may indicate like elements.

### DETAILED DESCRIPTION

The ensuing description provides embodiments only, and is not intended to limit the scope, applicability, or configuration of the claims. Rather, the ensuing description will provide those skilled in the art with an enabling description for implementing the described embodiments. It is understood that various changes may be made in the function and arrangement of elements without departing from the spirit and scope of the appended claims.

As used herein, the phrases "at least one," "one or more," "or," and "and/or" are openended expressions that are both conjunctive and disjunctive in operation. For example, each of the expressions "at least one of A, B and C," "at least one of A, B, or C," "one or more of A, B, and C," "one or more of A, B, or C," "A, B, and/or C," and "A, B, or C" means A alone, B alone, C alone, A and B together, A and C together, B and C together, or A, B and C together.

Various aspects of the present disclosure will be described herein with reference to drawings that are schematic illustrations of idealized configurations.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and this disclosure.

As used herein, the singular forms "a," "an," and "the" are intended to include the plural forms as well, unless the context clearly indicates otherwise. It will be further understood that the terms "comprise," "comprises," and/or "comprising," when used in this specification, specify the presence of stated features, integers, steps, operations, elements, and/or components, but do not preclude the presence or addition of one or more other features, integers, steps, operations, elements, components, and/or groups thereof. The term "and/or" includes any and all combinations of one or more of the associated listed items.

The present disclosure will be described more fully hereinafter with reference to the accompanying figures in which some but not all embodiments of the disclosures are shown. Indeed, the present disclosure may be embodied in many different forms and should not be construed as limited to the embodiments set forth herein.

Like numbers refer to like elements throughout. As used herein, terms such as "front," "rear," "top," etc. are used in the examples provided below to describe the position of certain components or portions of components in an installed and operational configuration. As used herein, the term "module" encompasses hardware, software and/or firmware configured to perform one or more particular functions, including but not limited to conversion between electrical and optical signals and transmission of the same. As would be evident to one of ordinary skill in the art in light of the present disclosure, the term "substantially" indicates that the referenced element or associated description is accurate to within applicable engineering tolerances.

Embodiments of the present disclosure are contemplated to be deployed in a datacenter environment. While embodiments will be described in connection with certain examples of datacenter environments, it should be appreciated that embodiments of the present disclosure are not so limited. Indeed, embodiments of the present disclosure may be deployed in any number of environments, including a datacenter environment or any other suitable environment that requires the management of thermal loads generated by computing components.

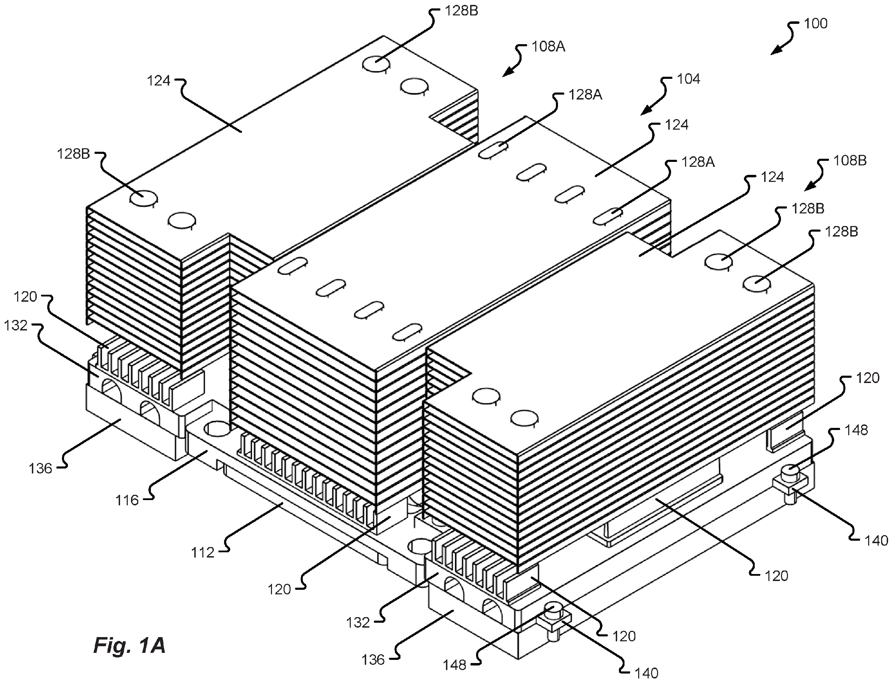

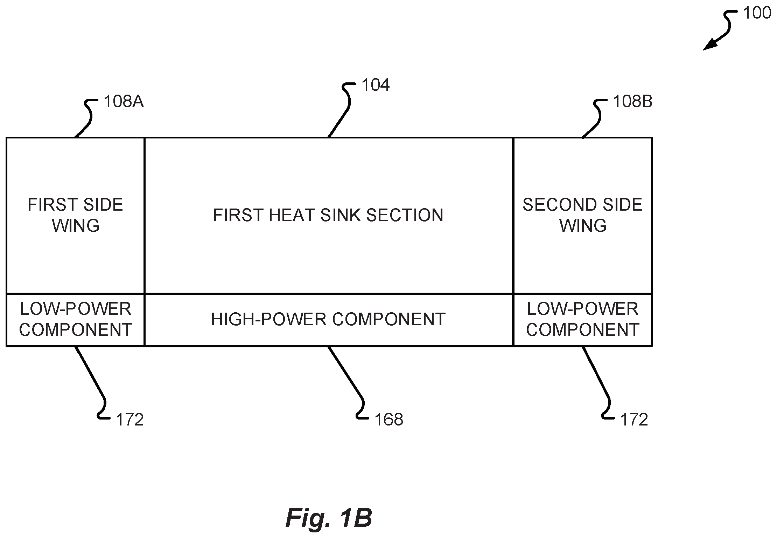

Split heat sinks according to embodiments of the present disclosure, as well as illustrative datacenter environments and components useful for fully understanding the present disclosure, are shown and will now be described with reference to Figs. 1 through 13.

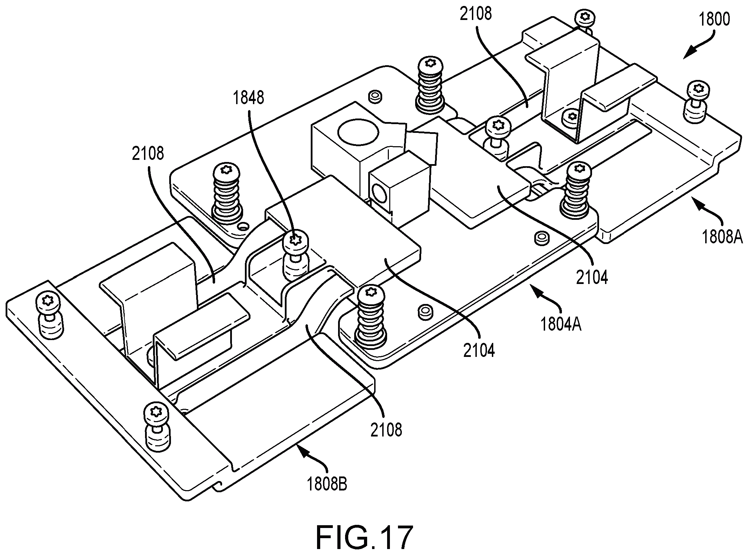

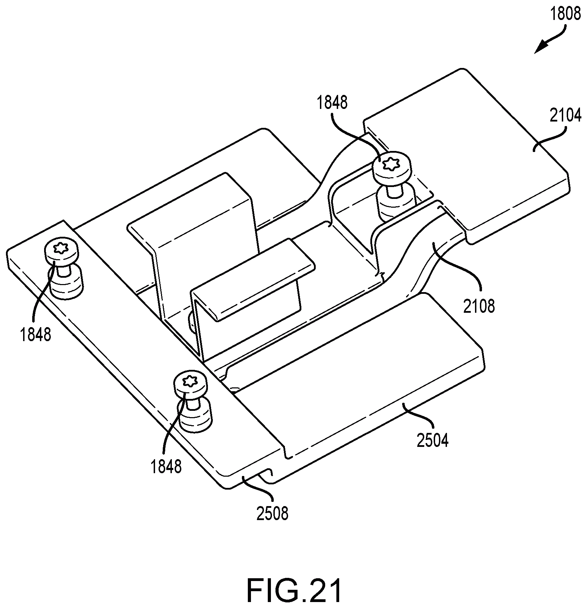

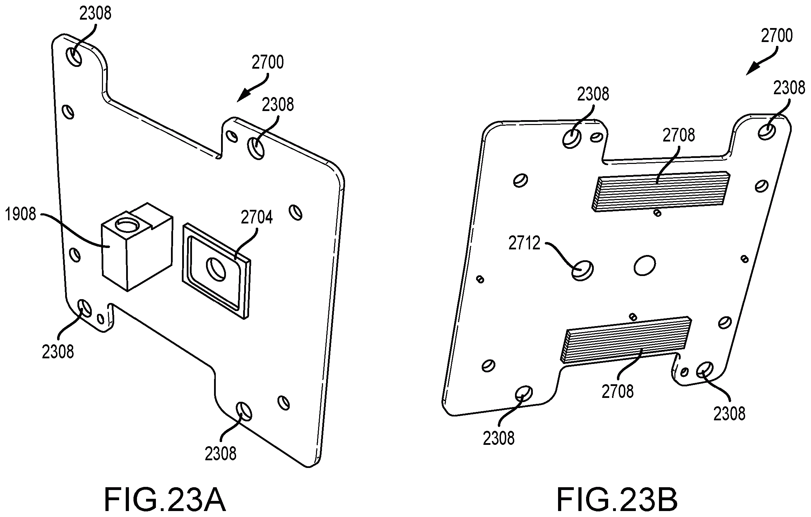

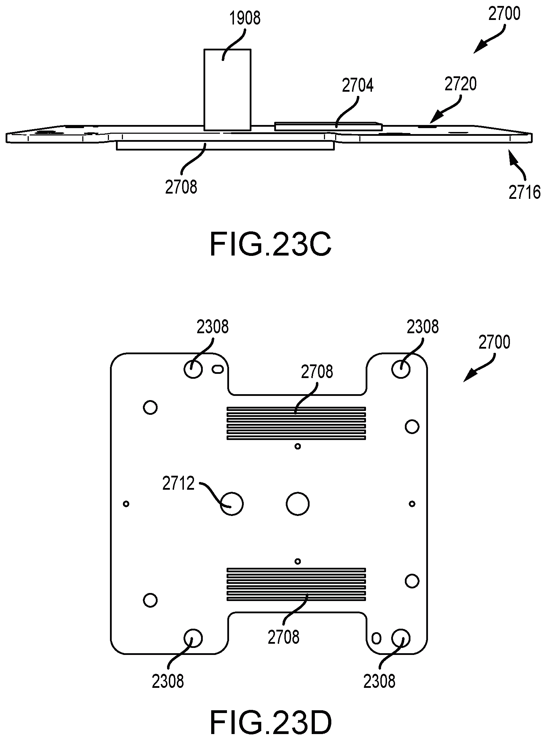

Figs. 1-8 and 14-24 depict various aspects of a split heat sink 100 according to embodiments of the present disclosure, and although portions of the following description may refer to a specific figure in describing a particular aspect of the split heat sink 100, the same or similar components may be depicted in other ones of the Figs. 1-8 and/or 14-24.

With general reference to Figs. 1-8 and specific reference to Figs. 1A and 1B, the split heat sink 100 comprises a central heat sink 104, a first side wing heat sink 108A, and a second side wing heat sink 108B. Throughout this disclosure, the central heat sink 104 may be referred to, for example, as a first section or a first heat sink section, and each of the first and second side wing heat sinks 108A, 108B may be referred to, for example, as a second section, a second heat sink section, a third section, and/or a third heat sink section. The first side wing heat sink 108A and the second side wing heat sink 108B are each individually detachable from the central heat sink 104, thus facilitating the servicing of computing hardware (including, for example, memory modules) positioned underneath one or both of the side wing heat sinks 108A and/or 108B. As further shown and described herein, however, when the first and second side wing heat sinks 108A and 108B are attached or connected to the central heat sink 104, each side wing heat sink 108A, 108B is thermally coupled to the central heat sink 104, and the split heat sink 100 provides integrated cooling for a processing unit, processing unit package, or other high-power component 168 operably connected to the central heat sink 104 while also providing cooling for the memory module or other low-power component 172 operably connected to each of the side wing heat sinks 108A, 108B.

The phrase "thermally coupled," as used herein, refers to two or more objects being connected in a way that facilitates heat transfer between the two objects, such that the two or more objects act as a single body (or as a substantially single body) from a heat transfer perspective. A "low-power component" within the meaning of the present disclosure includes any component that draws relatively less power (and as a result generates relatively less heat) than a CPU, GPU, or other processing unit or processing unit package on a motherboard, mainboard, blade, node, or other computing device. Thus, for example, a low-power component may be or include a randomaccess (or similar) memory unit (including any memory unit described herein), a chipset or platform controller hub, a high-speed interconnect, a baseboard management controller, a storage controller, a voltage regulator, and/or a power delivery circuit. In some embodiments, a low-power component may be or include any component that draws less than about 100W of power during operation.

Although shown in Figs. 1-8 as comprising a first section (e.g., the central heat sink 104), a second section (e.g., the first side wing heat sink 108A), and a third section (e.g., the second side wing heat sink 108B), split heat sinks according to embodiments of the present disclosure may comprise only a first section and a second section, with one configured to cool a high-powered component and the other configured to primarily cool a low-powered component while aiding in the cooling of the high-powered component. In other embodiments, a split heat sink may comprise more than three sections. For example, a split heat sink according to embodiments of the present disclosure may comprise four sections, or five sections, or six sections, or more sections. In such embodiments, the first section may be configured to extract heat generated by a high-powered component, and each of the remaining sections may be configured to extract heat generated by a separate, low-power component. Also in such embodiments, each of the sections configured to extract heat generated by a separate, low-power component may also be configured to aid in the dissipation of heat generated by the high-power component to which the first section is operably attached, in substantially the same manner as described herein with respect to the second and third sections.

Embodiments of the present disclosure that utilize more than three sections may utilize a variety of arrangements of each section. For example, in embodiments with four or five sections, each of the second, third, fourth, and (where present) fifth sections may be arranged adjacent one side of the substantially square or rectangular first section. In embodiments with six sections, the first section may have a substantially pentagonal shape, and each of the second through sixth sections may be arranged adjacent one side of the first section. In embodiments with seven sections, the first section may have a substantially hexagonal shape, and each of the second through seventh sections may be arranged adjacent one side of the first section.

Alternatively, additional sections beyond a third section may be secured adjacent to the second and third sections (e.g., in a manner that increases the length of the split heat sink but not its width, or in a manner that increases the width of the split heat sink but not its length). In still other embodiments, split heat sinks comprising more than three sections may be configured such that the second and any additional sections each comprises at least a portion that extends to and is thermally coupled with the first section, even though such portion may not be in substantially direct contact with an entire edge of the first section.

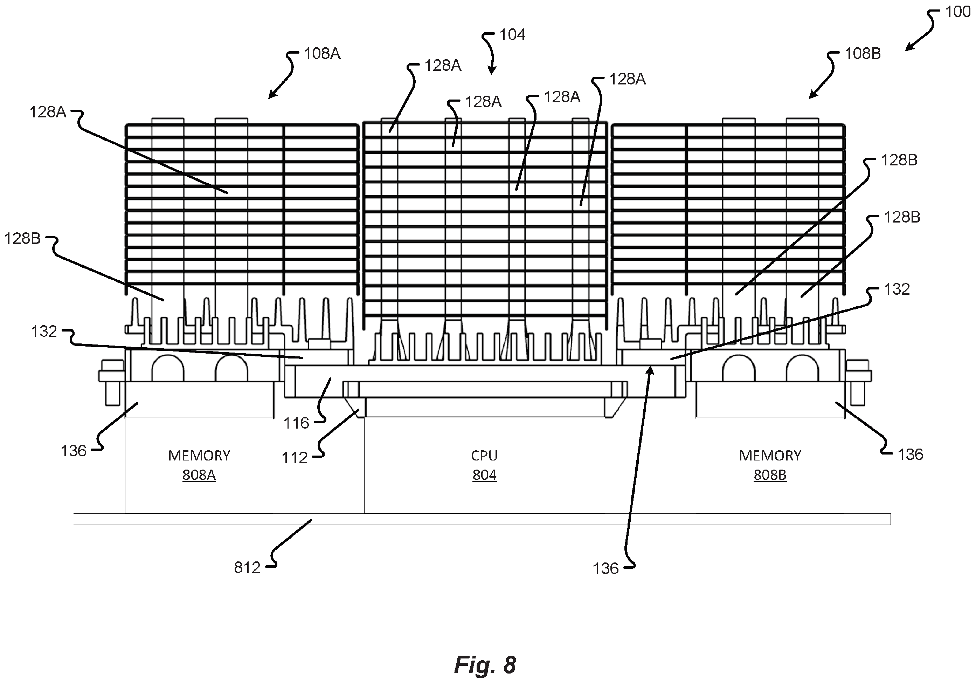

The central heat sink 104 comprises a vapor chamber 112 configured to be in thermal communication (whether through direct contact or otherwise) with a processing unit (e.g., a CPU or GPU), a processing unit package, or another high-powered component when in use. A stiffener base 116 is mounted over and partially surrounds the vapor chamber 112 to provide structural support for the components of the central heat sink 104 and ensure that the weight of the central heat sink 104 does not rest on the processing unit or other high-powered component to which the central heat sink 104 is mounted (e.g., the CPU 804 shown in Fig. 8).

Each heat sink section of the split heat sink 100 comprises one or more finned structures. More specifically, one or a plurality of vertical fins 120 may be mounted to the stiffener base 116, and one or a plurality of horizontal fins 124 may be stacked with even or irregular vertical spacing above the stiffener base 116. One or more heat pipes 128A may also be embedded in and/or mounted to the stiffener base 116 and extend up through the horizontal fins 124 to transfer heat to those horizontal fins 124.

Each of the side wing heat sinks 108A, 108B comprises a side wing base 132 that, similarly to the stiffener base 116, provides structural support for the components of the respective side wing heat sink 108A or 108B and helps to ensure that the weight of the side wing heat sink 108A or 108B does not rest on the memory module or other component to which the side wing heat sink 108A or 108B is thermally coupled (e.g., the memory modules 808A, 808B shown in Fig. 8). Each side wing base 132 may comprise one or more mounting tabs 140, each having a mounting hole 144 therein, configured to receive a removable mounting fastener 148 (e.g., a screw, a bolt, a pin) that secures the side wing base 132 to a printed circuit board (PCB) to which the components being cooled are connected (e.g., PCB 812, shown in Fig. 8) and/or to a rack or other structural element of a datacenter. The mounting tabs 140 may be integrally formed with the side wing base 132, or formed separately from the side wing base 132 and subsequently attached thereto using any known joining method (e.g., mechanical fasteners, welding, bonding).

Each side wing base 132 may also comprise one or more mounting holes 144 within the side wing base 132 itself, each configured to receive a removable mounting fastener 148 that secures the side wing base 132 to the stiffener base 116 of the central heat sink 104. The use of removable mounting fasteners 148 to secure the side wing bases 132 (and thus the side wing heat sinks 108A, 108B) to the central heat sink 104 and/or to an underlying substrate (e.g., a PCB) enables the side wing heat sinks 108A, 108B to be attachable to and detachable from the central heat sink 104 and/or the underlying substrate, thus facilitating removal of the side wing heat sinks 108A, 108B independently of the central heat sink 104.

The side wing bases 132 may be formed of copper, aluminum, a copper alloy, an aluminum alloy, another metal, and/or another metal alloy. A material and/or a thickness of the side wing bases 132 may be selected to ensure sufficient structural rigidity of the side wing heat sinks 108A, 108B. The side wing bases 132 comprise a plurality of heat pipe cutouts 134, which are configured to secure the heat pipes 128B so that a flat bottom surface thereof is in direct contact (or otherwise thermally coupled) with the vapor chamber 112 when the side wing heat sinks 108A, 108B are mounted to the central heat sink 104, and also so that the flat bottom surface thereof is thermally coupled (e.g., through the thermal interface material 136) to a low-power component (e.g., a memory 808A, 808B) that the side wing heat sinks 108A, 108B are intended to cool.

A thermal interface material 136 enhances thermal conductivity and ensures thermal coupling between the memory modules 808A, 808B or other low-power component operably connected to each of the side wing heat sink 108A, 108B. In some embodiments, the thermal interface material 136 may be, for example, a gap pad (rather than, for example, phase change material). Use of a gap pad rather than a phase change material simplifies the servicing process because the gap pad is easier to remove and replace, reducing the complexity of maintenance and thus also reducing the time required for maintenance.

A plurality of vertical fins 120 may be mounted to an upper surface of the side wing base 132, either directly or via a thermal interface material such as the thermal interface material 136. In some embodiments, additional thermal interface material 136 may be utilized between the stiffener base 116 and the vertical fins 120 of the central heat sink 104. The thermal interface material 136 may include any suitable type of thermal interface material (TIM), which may include, for example, a thermal grease, a gap pad, a phase change material, a thermal putty, combinations thereof, and the like. In some embodiments, the thermal interface material 136 may be compliant (e.g., compressible and/or soft) to help take up tolerance differences between at least one of the stiffener base 116, the first heat sink section 104, the second heat sink section(s) 108, the processing unit 804, and/or the memory module 808. The thermal interface material 136 may also be configured to provide substantially uniform cooling between components, as if the two components were physically contacting one another.

One or more heat pipes 128B may be mounted to and/or embedded in each side wing base 132. The heat pipes 128B are configured to extend upward through a plurality of horizontal fins 124, which may be stacked above the side wing base 132 with even or irregular vertical spacing along a height of the heat pipes 128B.

The vertical fins 120 utilized in the central heat sink 104 and in the first and second side wing heat sinks 108A, 108B may be manufactured from copper, aluminum, another metal, and/or any metal alloy. The thickness of each vertical fin 120, the spacing between any two vertical fins 120, as well as the length and height of each vertical fin 120 (or, alternatively, a surface area of each horizontal fin 124) may be selected to provide a desired level of heat dissipation. Additionally, the vertical fins 120 may be oriented on the stiffener base 116 and the side wing bases 132 so that air flowing past the split heat sink 100 passes between the individual vertical fins 120 and along the length of each vertical fin 120.

Similarly, the horizontal fins 124 utilized in the central heat sink 104 and the first and second side wing heat sinks 108A, 108B may be manufactured from copper, aluminum, another metal, and/or any metal alloy. The thickness of each horizontal fin 124, the spacing between any two horizontal fins 124 (e.g., the pitch of the horizontal fins 124), as well as the length and width of each horizontal fin 124 (or, alternatively, the surface area of each horizontal fin 124) may be selected to provide a desired level of heat dissipation.

The ability to thermally couple the side wing heat sinks 108A, 108B to the central heat sink 104, as described in the present disclosure, beneficially enables a coarser pitch between adjacent horizontal fins 124 on the various sections of the split heat sink 100 than would be possible if only the central heat sink 104 were used to extract and dissipate heat from a high-power component thermally coupled thereto. This beneficially results in a lower pressure drop across the heat sink, requiring less powerful fans to maintain a constant flow of air through the heat sink and reducing cost, complexity, and energy consumption of the overall cooling system.

In some embodiments, opposite edges of one or more horizontal fins 124 of the first, second, and/or third heat sink sections 104, 108A, and 108B, respectively may be bent downward (e.g., toward the next lower horizontal fin 124) or upward (e.g., toward the next higher horizontal fin 124) to ensure that air flowing between adjacent horizontal fins 124 passes along a length of the split heat sink 100. For example, on the first and second side wing heat sinks 108A, 108B, an edge of the horizontal fins 124 that is proximate the central heat sink 104 may be bent upward or downward as described, and the opposite edge of the same horizontal fins 124 may also be bent upward or downward as described. Similarly, on the central heat sink 104, an edge of the horizontal fins 124 facing the first side wing heat sink 108A may be bent upward or downward as described, and the opposite edge of the same horizontal fins 124 (e.g., the edge facing the second side wing heat sink 108B) also may be bent upward or downward as described.

The heat pipes 128A and 128B may be any type of heat pipe suitable for use with computing and/or datacenter hardware and may have the same or a different cross-sectional shape. In some embodiments, each heat pipe 128A and/or 128B may be made of copper, aluminum, or another metal or metal alloy, and may comprise a sealed chamber with a working fluid (e.g., water, ammonia, methanol, ethanol) disposed therein. The heat pipes 128A and 128B are configured to transfer heat generated by the computing components being cooled by the split heat sink 100 (e.g., a CPU 804, one or more memory modules 808A, 808B) up and into the horizontal fins 124, which are configured to absorb heat from the heat pipes and dissipate that heat (e.g., through convection to air or another fluid flowing over and past the horizontal fins 124). When the side wing heat sinks 108A, 108B are attached to the central heat sink 104, the heat pipes 128B in the side wing heat sinks 108A, 108B are thermally coupled with the vapor chamber 112 and are configured to conduct heat from the first heat sink section (e.g., the central heat sink 104) into the second and third heat sink sections (e.g., the side wing heat sinks 108A, 108B) for improved dissipation of heat generated by the high power component operably connected to the first heat sink section. In some embodiments, more or fewer heat pipes 128A, 128B may be accommodated within the central heat sink 104 and the side wing heat sinks 108A, 108B, respectively, and/or may have a different configuration within the central heat sink 104 and the side wing heat sinks 108A, 108B, respectively.

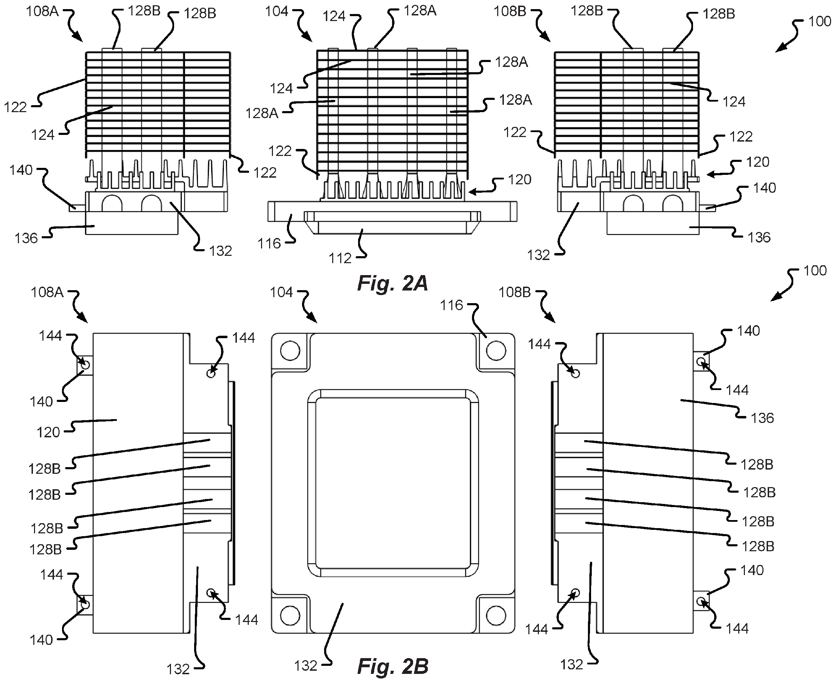

With reference now to Figs. 2A and 2B, each of the side wing heat sinks 108A, 108B may be independently attached to and detached from the central heat sink 104, from a PCB to which the split heat sink 100 is mounted (e.g., a PCB 812), and/or from a rack or other datacenter structural component to which the split heat sink 100 is mounted. Detachment may be achieved by removing mounting fasteners (e.g., screws, bolts, pins) such as the mounting fasteners 148 from the mounting holes 144 positioned proximate the corners of the side wing heat sink 108A or 108B. As noted above, in some embodiments, two of the mounting holes 144 are positioned in the side wing base 132, and two of the mounting holes 144 are positioned in mounting tabs 140 extending from the side wing base 132. However, the mounting holes 144 may be arranged differently in different embodiments, and different embodiments may have more or fewer mounting holes 144.

Still with general reference to Figs. 1-8 but as specifically shown in Fig. 2A, opposite edges 122 of each horizontal fin 124 of the central heat sink 104 and the side wing heat sinks 108A, 108B are bent downward so as to contact or nearly contact the next lower horizontal fin 124 (or, for the lowest horizontal fin 124, such that opposite edges 122 of the horizontal fin 124 extend downward toward the stiffener base 116 or the side wing base 132). As a result, the stacked horizontal fins 124 form essentially closed passageways for air flowing therethrough, helping to direct airflow in the same direction and ensure that air passes over an entirety of the surface of each horizontal fin 124. As also shown in Fig. 2A, all of the vertical fins 120 and horizontal fins 124 are arranged to facilitate air flow in the same direction through the split heat sink 100.

In embodiments of the present disclosure comprising more than three sections, the alignment of the vertical fins 120 and configuration of the horizontal fins 124 (and specifically of the bent edges 122 of the horizontal fins 124) on given section may be configured differently than on another section, so that when each of the second and additional sections are attached to the first section, the entire split heat sink is configured to direct airflow therethough in the same direction.

Referring generally to Figs. 1-8, and specifically as shown in Fig. 2B, the heat pipes 128B of each side wing heat sink 108A, 108B extend through the heat pipe cutouts 134 in the side wing base 132 toward the vapor chamber 112 of the central heat sink 104. When the side wing heat sinks 108A, 108B are attached to the central heat sink 104, a portion of each heat pipe 128B abuts the vapor chamber 112, thus facilitating the transfer of heat from the vapor chamber 112 to the horizontal fins 124 of the side wing heat sinks 108A, 108B. The thermal interface material 136 positioned underneath each side wing heat sink 108A, 108B also facilitates heat transfer from a memory module (e.g., a memory module 808A, 808B) or other low-power computing component operably connected to the side wing heat sinks 108A, 108B to the heat pipes 128B of the side wing heat sink 108A or 108B, which allows that heat to be transferred to the horizontal fins 124 of the side wing heat sink 108A or 108B for dissipation to the surrounding air or other fluid.

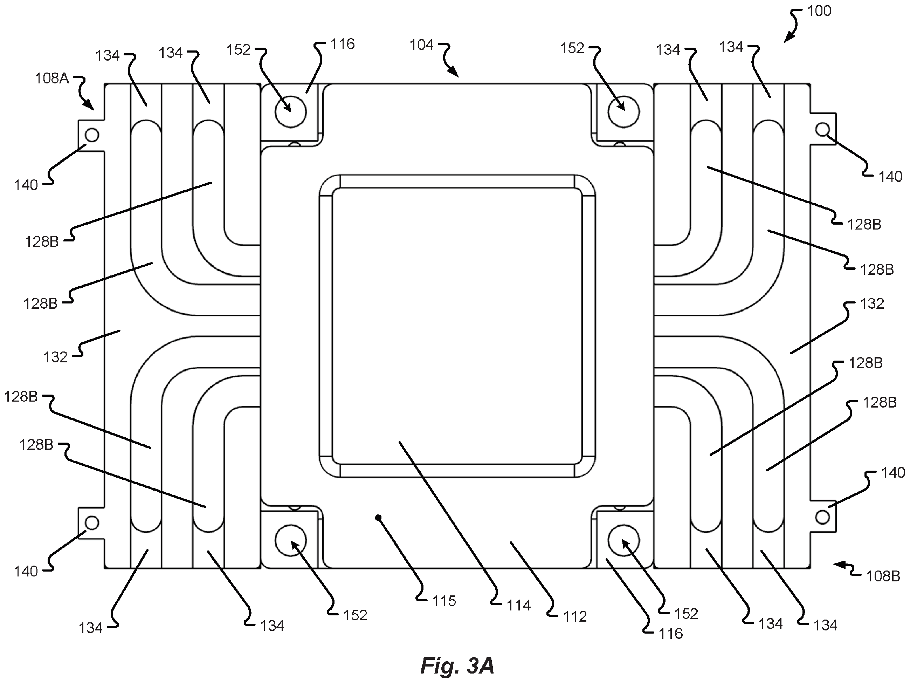

Fig. 3A depicts a bottom view of a split heat sink 100 according to at least some embodiments of the present disclosure, with the thermal interface material 136 of each side wing heat sink 108A, 108B removed. With the thermal interface material 136 removed, the arrangement of the heat pipes 128B is more readily visible. As can be seen, the heat pipes 128B are configured to maintain substantial surface area in contact with the thermal interface material 136 positioned thereon, thus facilitating heat transfer from the thermal interface material 136 to the heat pipes 128B. Also visible in Fig. 3A are the cutouts 134 in the side wing bases 132 in which the heat pipes 128B are embedded.

The stiffener base 116 comprises four holes 152 each configured to receive a mechanical fastener that secures the central heat sink 104 of the split heat sink 100 to an underlying PCB (e.g., the PCB 812) and/or to a rack or other structural element of a datacenter. In other embodiments, the stiffener base 116 may comprise more or fewer than four holes for this purpose.

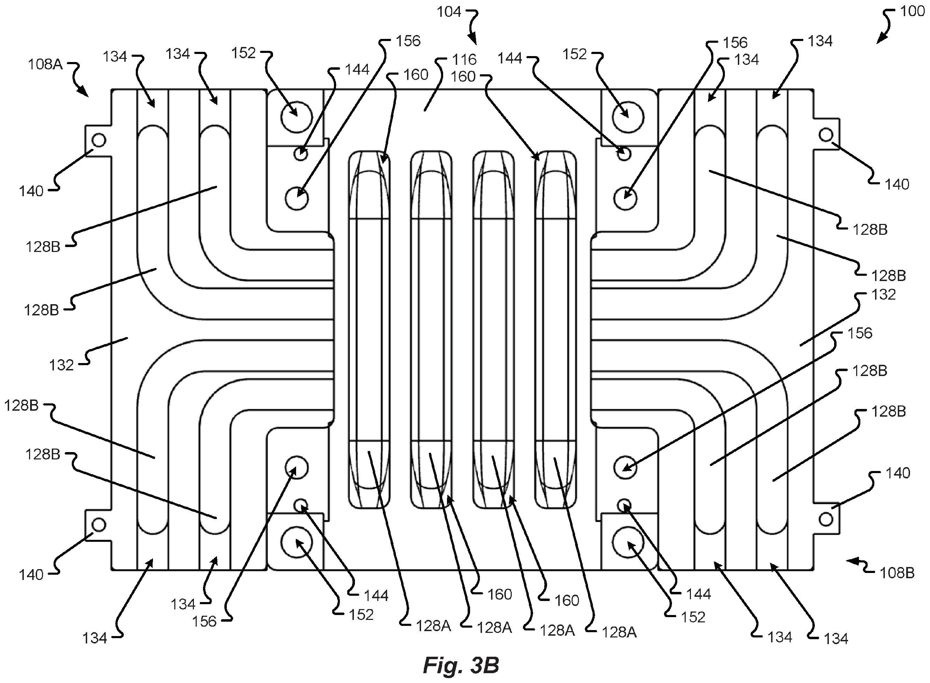

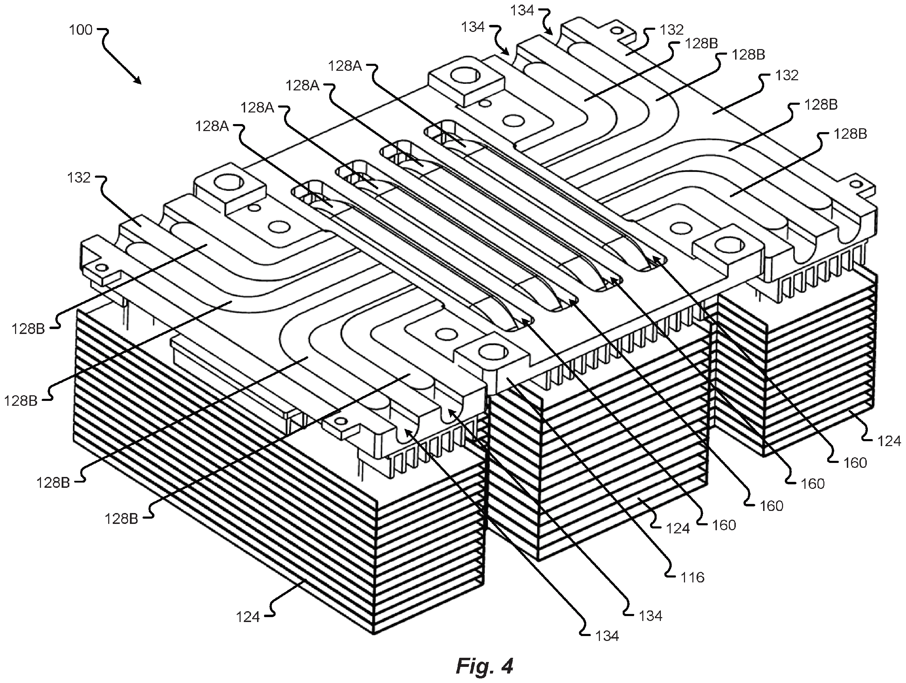

Figs. 3B and 4 show another bottom view of a split heat sink 100 according to at least some embodiments of the present disclosure, with the vapor chamber 112 removed from the central heat sink 104 as well as the thermal interface material 136 of each side wing heat sink 108A, 108B removed. In this view, the portions of the heat pipes 128B in direct contact with the vapor chamber 112 are visible, as are the bottom surfaces of the heat pipes 128A that are also in direct contact with the vapor chamber 112 during operation of the split heat sink 104. In some embodiments, thermal interface material such as the thermal interface material 136 may be used to fill any gaps between the heat pipes 128A and the vapor chamber 112, and/or to ensure the thermal coupling of the heat pipes 128A and the vapor chamber 112. The heat pipes 128A are visible through the cutouts 160 in the stiffener base 116, which they heat pipes 128A are embedded. The cutouts 160 may be configured to receive the heat pipes 128A with a minimal gap or no gap between each heat pipe 128A and adjacent walls of the corresponding cutout 160, so as to enable and improve heat transfer (e.g., through conduction) from the stiffener base 116 to the heat pipes 128A. Each of the heat pipes 128A has a flat bottom surface to increase the amount of surface area in contact with the vapor chamber 112 and/or the thermal interface material 136, and thus improve heat transfer into the heat pipes 128A and through the heat pipes 128A to the horizontal fins 124.

With the vapor chamber 112 removed, also visible in the stiffener base 116 are the holes 144 used to secure the side wing heat sinks 108A, 108B to the central heat sink 104, as well as the holes 156 used for mounting the vapor chamber 112 to the stiffener base 116 (or vice versa). In various embodiments of the present disclosure, the vapor chamber 112 may be mounted to the stiffener base 116 using mechanical fasteners (e.g., screws, bolts, pins, rivets), adhesive, thermal interface material, and/or any other suitable mounting system, material, and/or method. Where mechanical fasteners are used, the mechanical fasteners may be the same as or similar to the mechanical fasteners 148 described herein. Additionally, in some embodiments the number of holes 144 and 156 in the stiffener base 116 may be more or fewer than four.

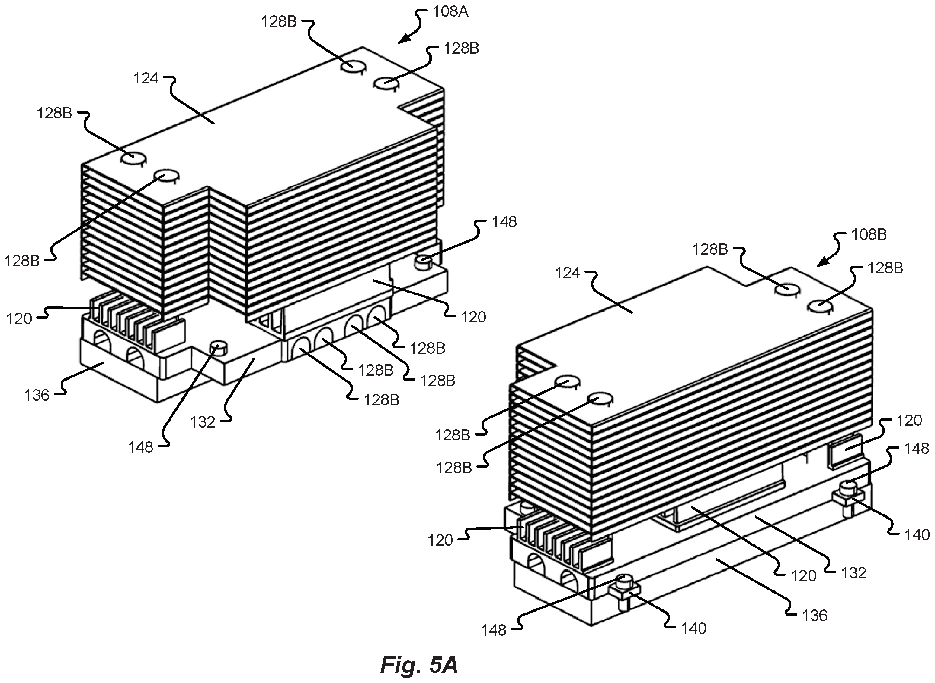

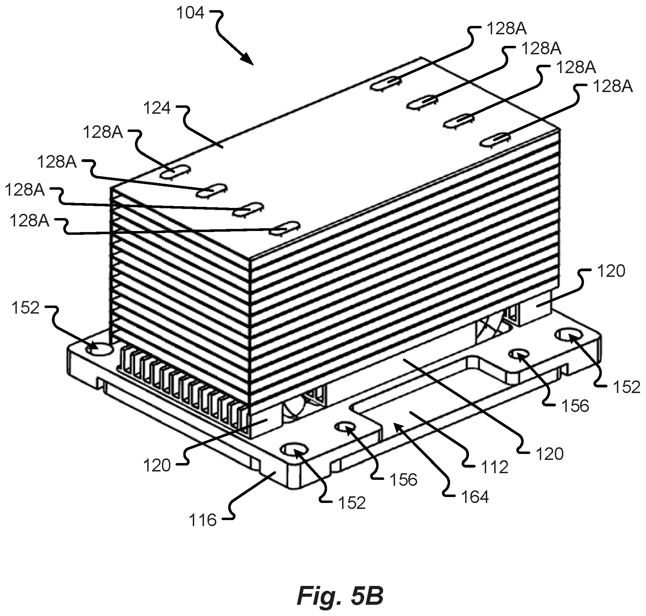

As can be seen in the perspective views of Figs. 5A and 5B, the stiffener base 116 comprises a side cutout 164 that exposes a portion of the upper surface of the vapor chamber 112 and forms a connection interface for the side wing heat sinks 108A, 108B. More specifically, side cutouts 164 receive a portion of the first and second side wing heat sinks 108A, 108B (e.g., a portion of the side wing base 132 of each side wing heat sink 108A, 108B), such that a portion of a bottom surface of each of the heat pipes 128B abuts the exposed upper surface of the vapor chamber 112 when the side wing heat sinks 108A, 108B are secured to the central heat sink 104. In some embodiments, the bottom surface of each of the heat pipes 128B may be in direct contact with the vapor chamber 112 (e.g., with the portion of the upper surface of the vapor chamber 112 exposed by the side cutouts 164). In other embodiments, a thermal interface material 136 may be positioned between the heat pipes 128B and the vapor chamber 112 to ensure thermal coupling between those components and to facilitate heat transfer from the vapor chamber 112 to the heat pipes 128B. Thermal interface material such as the thermal interface material 136 may be utilized between any two components of the split heat sink 100 as described herein to improve thermal coupling between such components, regardless of whether the components are permanently or removably secured to or proximate each other.

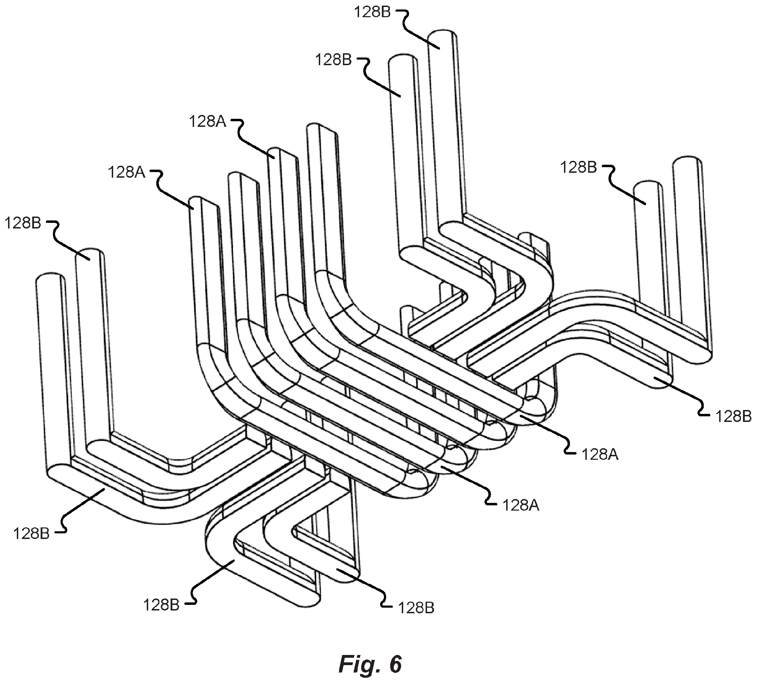

Fig. 6 depicts just the heat pipes 128A, 128B of the split heat sink 100, which are carefully configured and arranged to extract heat from the vapor chamber 112 and transfer that heat through the horizontal fins of the central heat sink 104 and the side wing heat sinks 108A, 108B. As a result, the split heat sink 100 is able to provide sufficient cooling to the processing unit (e.g., the CPU 804) being cooled by the split heat sink 100, while still enabling the side wing heat sinks 108A, 108B to be removed to facilitate servicing of the low-power computing component(s) thereunder (e.g., the memory modules 808A, 808B). Additionally, the heat pipes 128B are configured to receive heat from those same low-power computing components (e.g., the memory modules 808A, 808B) and transfer that heat, in addition to the heat received from the vapor chamber 112, to the horizontal fins 124 of the side wing heat sinks 108A, 108B.

Although Fig. 6 (and, more generally, Figs. 1-8) depict a specific configuration of heat pipes 128A and 128B, embodiments of the present disclosure include other heat pipe configurations. In some embodiments, one or more of the first section (e.g., the central heat sink 104), the second section (e.g., the first side wing heat sink 108A), and the third section (e.g., the second side wing heat sink 108B) comprises only a single heat pipe 128A or 128B. Also in some embodiments, one or more of the first, second, and third sections comprises fewer or more heat pipes 128A, 128B than depicted in Figs. 1-8. Additionally, regardless of whether the first, second, and/or third sections comprise the same or a different number of heat pipes 128A, 128B, those heat pipes may be arranged or configured differently than as shown in Fig. 6. In some embodiments, one or more heat pipes 128A in the central heat sink 104 may have a different cross-section than one or more other heat pipes 128A in the central heat sink 104. Also in some embodiments, one or more heat pipes 128B in either or both of the first and second side wing heat sinks 108A, 108B may have a different cross-section than one or more other heat pipes 128B in the same heat sink section.

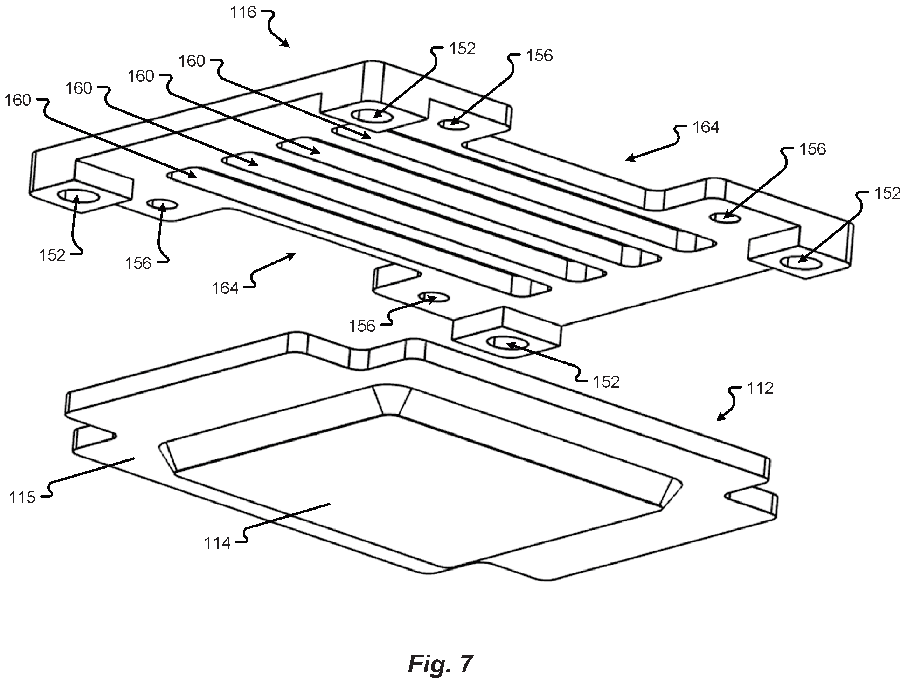

With continued general reference to Figs. 1-8, and specifically with reference to Fig. 7, the vapor chamber 112 may be, for example, a heat transfer device with a fluid inside that alternately evaporates and condenses to quickly spread heat over the surface area of the vapor chamber 112. The vapor chamber 112 may be formed of copper, a copper alloy, another metal or metal alloy, or another thermally conductive material. In some embodiments, the vapor chamber 112 may comprise a sealed chamber 114 with a working fluid contained therein. The working fluid may be, for example, water, ammonia, methanol, or ethanol. The sealed chamber 114 may extend below a bottom surface 115 of the vapor chamber 112. The sealed chamber 114 may be shaped so as to fit precisely over the entirety of a processing unit or processing unit package, such as the CPU 804.

The stiffener base 116 may be formed of copper, aluminum, a copper alloy, an aluminum alloy, another metal, and/or another metal alloy. A material and/or a thickness of the stiffener base 116 may be selected to ensure sufficient structural rigidity of the central heat sink 104 and/or of the entire split heat sink 100. The stiffener base 116 comprises a plurality of heat pipe cutouts 160, which are configured to secure the heat pipes 128A so that a flat bottom surface thereof is in direct contact with the vapor chamber 112 when the vapor chamber 112 is mounted to or within the stiffener base 116 (or vice versa). The stiffener base 116 also comprises one or more side cutouts 164 that expose a portion of an upper surface of the vapor chamber 112 (opposite the bottom surface 115) to allow efficient heat transfer from a high-power component thermally coupled the vapor chamber 112 to the heat pipes 128B of the side wing heat sinks 108A, 108B.

Fig. 8 depicts a side view of a heat sink 100 according to at least some embodiments of the present disclosure, arranged in an operational configuration with (e.g., thermally coupled to) a CPU 804, a memory module 808A, and a memory module 808B, each of which is mounted to a PCB 812. The PCB 812 carries electrical signals between or among the CPU 804, the memory module 808A, and/or the memory module 808B. As shown in Fig. 8, the CPU 804 is in direct contact with the vapor chamber 112 (although, in some embodiments, a thermal interface material such as the thermal interface material 136 may be utilized to ensure thermal coupling between the CPU 804 and the vapor chamber 112). Similarly, a portion of the side wing base 132 of each side wing heat sink 108A, 108B is received into the side cutouts 164 (not visible in Fig. 8) of the stiffener base 116, which in turn allows the heat pipes 128B of the side wing heat sinks 108A, 108B to contact the vapor chamber 112 and transfer heat away from the vapor chamber 112.

If an operator of a datacenter comprising the CPU 804, the memory modules 808A, 808B, and the heat sink 100 needs to replace or otherwise service, for example, the memory module 808A, the split heat sink 100 according to embodiments of the present disclosure would allow the operator to detach just the side wing heat sink 108A from central heat sink 104 and/or from the PCB 812, remove the side wing heat sink 108A, remove the memory module 808A, install the memory module 808A post-service (or install a new memory module 808A), and re-attach the side wing heat sink 108A to the central heat sink 104 and/or to the PCT 812, all without having to uninstall (and subsequently reinstall) the remainder of the split heat sink 100. Substantially the same procedure could be utilized to service the memory module 808B by detaching and then reattaching just the second side wing heat sink 108B. As a result, embodiments of the present disclosure facilitate improved serviceability, reduced wear on computing components (resulting, for example, from repeating installation/uninstallation cycles), and less down time for data center operators, thus reducing costs, maintenance efforts and improving performance.

The CPU 804 represents any suitable processing unit, processing unit package, or other high-power component that might be utilized, for example, in a datacenter environment, including any processing unit, processing unit package, and/or high-power component described herein. For the avoidance of doubt, the CPU 804 may represent, for example, a GPU, a Quantum Processing Unit (QPU), a Parallel Processing Unit (PPU), an Application-Specific Integrated Chip (ASIC), and/or any other processing unit or similar silicon package that generates heat during use.

Each of the memory modules 808A, 808B represents a memory module or other low-power component that might be utilized, for example, in a datacenter environment, and that might be operably connected to the CPU 804 (or other processing unit, processing unity package, or high-power component) via a PCB 812. The memory modules 808A, 808B may be, for example, a Small Outline Compression Attached Memory Module (SOCAMM); a High Bandwidth Memory (HBM); a Hybrid Memory Cube (HMC); a Dual In-Line Memory Module (DIMM); a network module; an optical module; a re-timer; a Mid-Board Optical Module (MBOM); any other memory, memory module, or low-power component described herein; and/or any other memory module or low-power component.

Although the present disclosure discusses the use of a split heat sink such as the split heat sink 100 with a processing unit and one or more memories, split heat sinks according to embodiments of the present disclosure may be utilized in any application requiring cooling of a high-powered component and one or more neighboring lower-powered components.

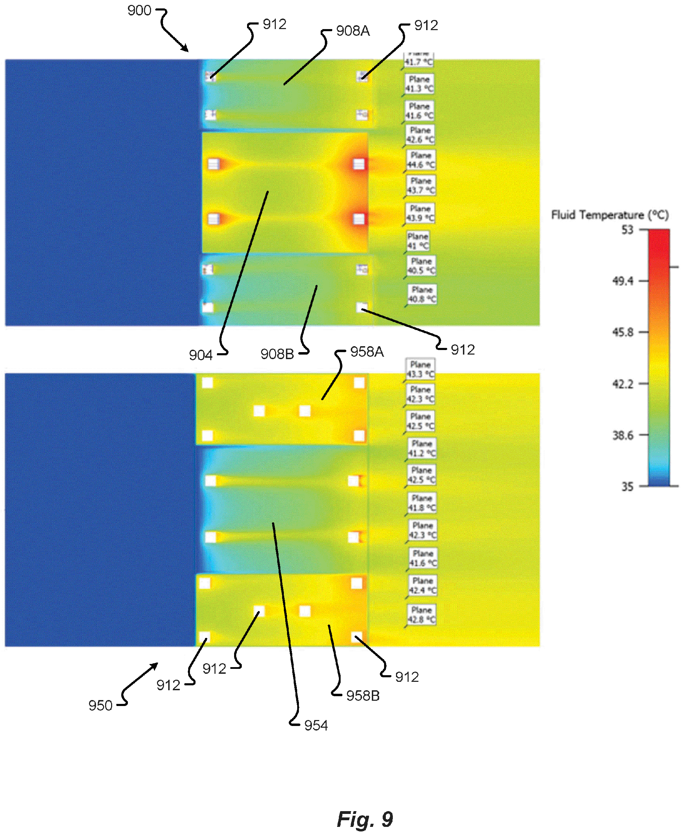

Fig. 9 illustrates a heat map showing two different split heat sink configurations similar to the heat sink 100 described above during use. The first configuration utilizes a split heat sink 900 (substantially similar to the heat sink 100 of Figs. 1-8) having a central heat sink 904, two side wing heat sinks 908A, 908B, and a plurality of heat pipes 912 (e.g., for transferring heat from computing components underneath the split heat sink 900 to horizontal fins such as the horizontal fins 124). The second configuration utilizes a split heat sink 950 (also substantially similar to the heat sink 100 of Figs. 1-8) having a central heat sink 954, two side wing heat sinks 958A, 958B, and a plurality of heat pipes 912 (e.g., for transferring heat from computing components underneath the split heat sink 950 to horizontal fins such as the horizontal fins 124). The split heat sink 900 and the split heat sink 950 differed from each other in their arrangement of the heat pipes 912, with the split heat sink 950 comprising two extra heat pipes rising through the horizontal fins of the side wing heat sinks 958A, 958B.

As evident from Fig. 9, the design of the split heat sinks 900, 950 allows a uniform heat distribution between the CPU heat sink (e.g., the central heat sinks 904, 954) and the side wing heat sinks (e.g., the side wing heat sinks 908A, 908B, 958A, 958B). Even for the worst-case tolerance stack-up on the side wing heat sinks, where one side wing heat sink is the tallest possible and the other is the shortest possible (e.g., due to manufacturing errors in manufacturing/assembling the side wing heat sinks), the temperature distribution downstream of the heat sink is still relatively uniform. In the test that yielded the heat maps depicted in Fig. 9, there was a height difference of 0.6 mm between the two side wings, resulting in a thermal interface material layer between one side wing (e.g., the side wing heat sink 908A, 958A) and the central heat sink (e.g., the central heat sink 904, 954) being 1.3mm thick, and a thermal interface material layer between the other side wing (e.g., the side wing heat sink 908B, 958B) and the central heat sink (e.g., the central heat sink 904, 954) being 0.7mm thick. The results shown in Fig. 9 were also obtained notwithstanding the non-uniformity in and tolerances of the thermal interface material itself.

To achieve the results depicted in Fig. 9, a 300W CPU was used under the central heat sink 904, 954, and a 40W SOCAMM module was used under each side wing heat sink 908A, 908B, 958A, 958B. The inlet air temperature was 35 degrees Celsius, and the air flow rate through the split heat sinks 900, 950 was 75 cubic feet per minute. For the split heat sink 900, the air temperature across the length of the split heat sink (e.g., from one end of the side wing heat sink 908A to an opposite end of the side wing heat sink 908B) had a maximum variation of 4.1 degrees Celsius (ranging from 40.5 to 41.6 degrees Celsius). For the split heat sink 950, the air temperature across the length of the split heat sink (e.g., from one end of the side wing heat sink 958A to an opposite end of the side wing heat sink 958B) had a maximum variation of 2.1 degrees Celsius (ranging from 41.2 to 43.3 degrees Celsius). These results demonstrate that uniform heat spreading between the side wings of the split heat sink according to embodiments of the present disclosure can be achieved even with undesirable tolerance stack-up.

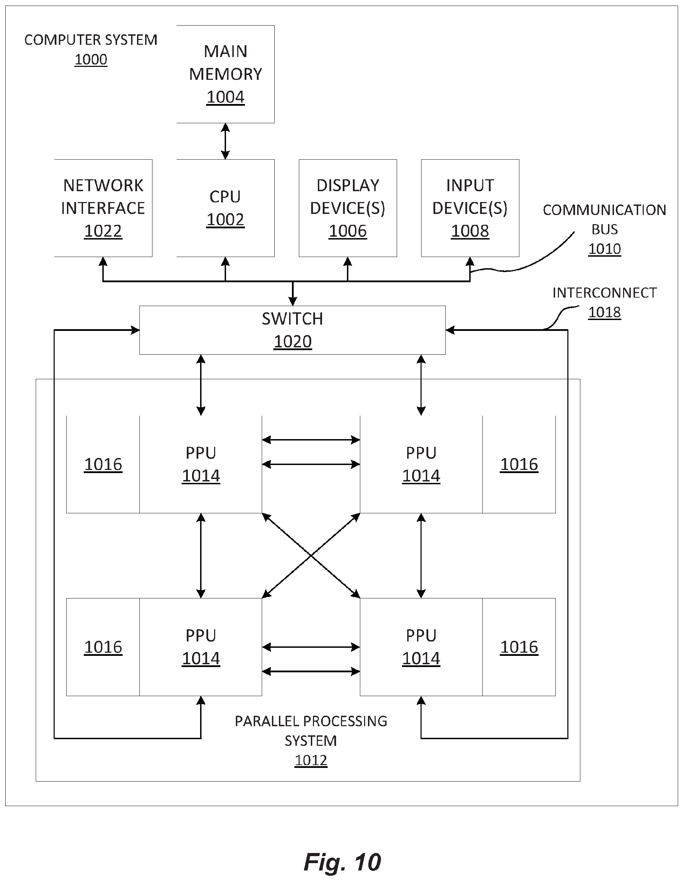

Various aspects and embodiments of a datacenter in which a split heat sink as described above may be used, as well as of components of such a datacenter, will now be described, with reference to Figs. 10-13. Fig. 10 illustrates a computer system 1000, according to at least one embodiment. In at least one embodiment, the systems and devices described throughout this disclosure may be implemented in connection with a computer system such as the computer system 1000.

In at least one embodiment, computer system 1000 comprises, without limitation, at least one central processing unit ("CPU") 1002 that is connected to a communication bus 1010 implemented using any suitable protocol, such as PCI ("Peripheral Component Interconnect"), peripheral component interconnect express ("PCI-Express"), AGP ("Accelerated Graphics Port"), HyperTransport, or any other bus or point-to-point communication protocol(s). In at least one embodiment, computer system 1000 includes, without limitation, a main memory 1004. Control logic (e.g., implemented as hardware, software, or a combination thereof) and data are stored in main memory 1004 which may take form of random access memory ("RAM"). In at least one embodiment, a network interface subsystem ("network interface") 1022 provides an interface to other computing devices and networks for receiving data from and transmitting data to other systems from computer system 1000.

In at least one embodiment, computer system 1000, includes, without limitation, input devices 1008, parallel processing system 1012, and display devices 1006 which can be implemented using a conventional cathode ray tube ("CRT"), liquid crystal display ("LCD"), light emitting diode ("LED"), plasma display, or other suitable display technologies. In at least one embodiment, user input is received from input devices 1008 such as keyboard, mouse, touchpad, microphone, and more. In at least one embodiment, each of the foregoing modules can be situated on a single semiconductor platform to form a processing system.

In at least one embodiment, computer programs in the form of machine-readable executable code or computer control logic algorithms are stored in main memory 1004 and/or secondary storage. Computer programs, if executed by one or more processors, enable system 1000 to perform various functions in accordance with at least one embodiment. Memory 1004, secondary storage, and/or any other storage are possible examples of computer-readable media. In at least one embodiment, secondary storage may refer to any suitable storage device or system such as a hard disk drive and/or a removable storage drive, representing a floppy disk drive, a magnetic tape drive, a compact disk drive, digital versatile disk ("DVD") drive, recording device, universal serial bus ("USB") flash memory, etc. In at least one embodiment, the architecture and/or functionality of various figures described herein is/are implemented in the context of CPU 1002; parallel processing system 1012; an integrated circuit capable of at least a portion of capabilities of both CPU 1002 and parallel processing system 1012; a chipset (e.g., a group of integrated circuits designed to work and sold as a unit for performing related functions, etc.); and any suitable combination of integrated circuit(s).

In at least one embodiment, the architecture and/or functionality of various figures described herein is/are implemented in the context of a general computer system, a circuit board system, a game console system dedicated for entertainment purposes, an application-specific system, and more. In at least one embodiment, computer system 1000 may take form of a desktop computer, a laptop computer, a tablet computer, servers, supercomputers, a smart-phone (e.g., a wireless, hand-held device), personal digital assistant ("PDA"), a digital camera, a vehicle, a head mounted display, a hand-held electronic device, a mobile phone device, a television, workstation, game consoles, embedded system, and/or any other type of logic.

In at least one embodiment, parallel processing system 1012 includes, without limitation, a plurality of parallel processing units ("PPUs") 1016 and associated memories 1016. In at least one embodiment, PPUs 1016 are connected to a host processor or other peripheral devices via an interconnect 1018 and a switch 1020 or multiplexer. In at least one embodiment, parallel processing system 1012 distributes computational tasks across PPUs 1016 which can be parallelizable-for example, as part of a distribution of computational tasks across multiple graphics processing unit ("GPU") thread blocks. In at least one embodiment, memory is shared and accessible (e.g., for read and/or write access) across some or all of PPUs 1016, although such shared memory may incur performance penalties relative to the use of local memory and registers resident to a PPU 1016. In at least one embodiment, operation of PPUs 1016 is synchronized through use of a command such as syncthreads( ), which requires all threads in a block (e.g., executed across multiple PPUs 1016) to reach a certain point of execution of code before proceeding.

Each of the CPU 1002 and the PPUs 1014 illustrated in Fig. 10 may be cooled, for example, using embodiments of the present disclosure.

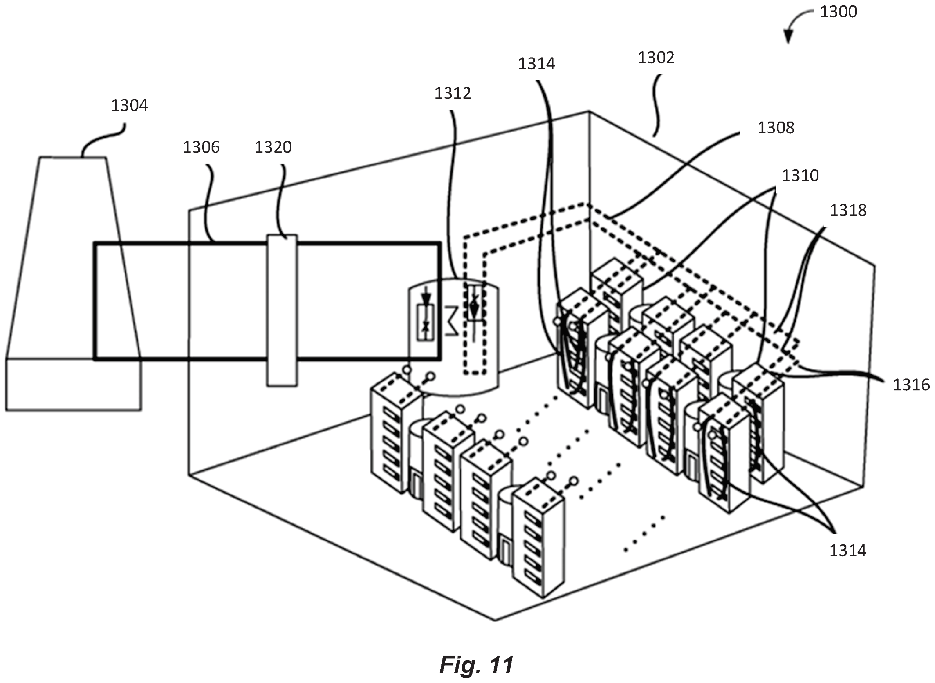

According to at least some embodiments of the present disclosure, an exemplary datacenter 1300 can be utilized as illustrated in Fig. 11, which has a cooling system subject to improvements described herein. Any one or more of the features described above may be utilized in a datacenter such as the datacenter 1300. Numerous specific details are set forth to provide a thorough understanding, but concepts herein may be practiced without one or more of these specific details.

In at least one embodiment, datacenter cooling systems can respond to sudden high heat requirements caused by changing computing-loads in present day computing components. In at least one embodiment, as these requirements are subject to change or tend to range from a minimum to a maximum of different cooling requirements, these requirements must be met in an economical manner, using an appropriate cooling system. In at least one embodiment, for moderate to high cooling requirements, liquid cooling system may be used. In at least one embodiment, high cooling requirements are economically satisfied by localized immersion cooling. In at least one embodiment, these different cooling requirements also reflect different heat features of a datacenter. In at least one embodiment, heat generated from these components, servers, and racks are cumulatively referred to as a heat feature or a cooling requirement as cooling requirement must address a heat feature entirely.

In at least one embodiment, a split heat sink system is disclosed. In at least one embodiment, this split heat sink system addresses heat features in associated computing or datacenter devices, including graphics processing units (GPUs), central processing units (CPUs), switches, and dual inline memory modules (DIMMs). In at least one embodiment, these components may be referred to herein as high heat density computing components or simply high-power components. Furthermore, in at least one embodiment, an associated computing or datacenter device may be a processing card having one or more GPUs, switches, or CPUs thereon. In at least one embodiment, each of the GPUs, switches, and CPUs may be a heat generating feature of a computing device. In at least one embodiment, a GPU, a CPU, or a switch may have one or more cores, and each core may be a heat generating feature.

In at least one embodiment, a split heat sink as described above, and more specifically a central heat sink or a first heat sink section as described above, may be thermally coupled to one or more of the high-power components described above. In some embodiments, a liquid cooling system may be used instead of or in addition to (or simply with other datacenter components than) the split heat sink.

In at least one embodiment, an exemplary datacenter 1300 can be utilized as illustrated in Fig. 11, which has a cooling system subject to improvements described herein. In at least one embodiment, a datacenter 1300 may be or comprise one or more rooms 1302 having racks 1310 and auxiliary equipment to house one or more servers on one or more server trays. In at least one embodiment, a datacenter 1300 is supported by a cooling tower 1304 located external to a datacenter 1300. In at least one embodiment, a cooling tower 1304 dissipates heat from within a datacenter 1300 by acting on a primary cooling loop 1306. In at least one embodiment, a cooling distribution unit (CDU) 1312 is used between a primary cooling loop 1306 and a second or secondary cooling loop 1308 to enable absorption of heat from a second or secondary cooling loop 1308 to a primary cooling loop 1306. In at least one embodiment, a secondary cooling loop 1308 can access various plumbing into a server tray as required, in an aspect. In at least one embodiment, loops 1306, 1308 are illustrated as line drawings, but a person of ordinary skill would recognize that one or more plumbing features may be used. In at least one embodiment, flexible polyvinyl chloride (PVC) pipes may be used along with associated plumbing to move fluid along in each provided loop 1306; 1308. In at least one embodiment, one or more coolant pumps may be used to maintain pressure differences within coolant loops 1306, 1308 to enable movement of coolant according to temperature sensors in various locations, including in a room, in one or more racks 1310, and/or in server boxes or server trays within one or more racks 1310.

In at least one embodiment, coolant in a primary cooling loop 1306 and in a secondary cooling loop 1308 may be at least water and an additive. In at least one embodiment, an additive may be glycol or propylene glycol. In operation, in at least one embodiment, each of a primary and a secondary cooling loops may have their own coolant. In at least one embodiment, coolant in secondary cooling loops may be proprietary to requirements of components in a server tray or in associated racks 1310. In at least one embodiment, a CDU 1312 is capable of sophisticated control of coolants, independently or concurrently, within provided coolant loops 1306, 1308. In at least one embodiment, a CDU may be adapted to control flow rate of coolant so that coolant is appropriately distributed to absorbed heat generated within associated racks 1310. In at least one embodiment, more flexible tubing 1314 is provided from a secondary cooling loop 1308 to enter each server tray to provide coolant to electrical and/or computing components therein.

The heat transfer fluid generally includes water, water solutions (e.g. propylene glycolwater), brine, antifreeze, a mixture of antifreeze and water, oil, alcohol, mercury or the like or any other suitable heat conductive fluid. The heat transfer fluid may be an electrically conductive cooling liquid and may include water, deionized water, or a coolant such as R-134a, a mixture of water and additives, such as a mixture of water and ethylene glycol or a mixture of water and propylene glycol e.g. a 25% concentration of propylene glycol in deionized water. The heat transfer fluid may also be a dielectric fluid alone (e.g., not having water for purposes of this disclosure) or a water in combination with an additive including at least one dielectric fluid, such as or one or more of de-ionized water, ethylene glycol, and propylene glycol. In at least one embodiment, the heat transfer fluid may be an absorption chiller having a working fluid being a mixed solution containing lithium bromide as the absorbent material and water as the carrier material. The heat transfer fluid may also be a two-phase coolant that has a boiling point that is below the expected operating temperature of the electronic devices. Exemplary two-phase coolants include 2, 3, 3, 3-tetrafluoropropene, 1, 1, 1, 2-tetrafluoroethane and water.

In at least one embodiment, tubing 1318 that forms part of a secondary cooling loop 1308 may be referred to as room manifolds. Separately, in at least one embodiment, further tubing 1316 may extend from row manifold tubing 1318 and may also be part of a secondary cooling loop 1308 but may be referred to as row manifolds. In at least one embodiment, coolant tubing 1314 enters racks as part of a secondary cooling loop 1308 but may be referred to as rack cooling manifold within one or more racks. In at least one embodiment, row manifolds 1316 extend to all racks along a row in a datacenter 1300. In at least one embodiment, plumbing of a secondary cooling loop 1308, including coolant manifolds 1318, 1316, and 1314 may be improved by at least one embodiment herein. In at least one embodiment, a chiller 1320 may be provided in a primary cooling loop within datacenter 1302 to support cooling before a cooling tower. In at least one embodiment, additional cooling loops that may exist in a primary control loop and that provide cooling external to a rack and external to a secondary cooling loop, may be taken together with a primary cooling loop and is distinct from a secondary cooling loop, for this disclosure.

In at least one embodiment, in operation, heat generated within server trays of provided racks 1310 may be transferred to a coolant exiting one or more racks 1310 via flexible tubing of a row manifold 1314 of a second cooling loop 1308. In at least one embodiment, second coolant (in a secondary cooling loop 1308) from a CDU 1312, for cooling provided racks 1310, moves towards one or more racks 1310 via provided tubing. In at least one embodiment, second coolant from a CDU 1312 passes from one side of a room manifold having tubing 1318, to one side of a rack 1310 via a row manifold 1316, and through one side of a server tray via different tubing 1314. In at least one embodiment, spent or returned second coolant (or exiting second coolant carrying heat from computing components) exits out of another side of a server tray (such as enters left side of a rack and exits right side of a rack for a server tray after looping through a server tray or through components on a server tray). In at least one embodiment, spent second coolant that exits a server tray or a rack 1310 comes out of different side (such as exiting side) of tubing 1314 and moves to a parallel, but also exiting side of a row manifold 1316. In at least one embodiment, from a row manifold 1316, spent second coolant moves in a parallel portion of a room manifold 1318 and is going in an opposite direction than incoming second coolant (which may also be renewed second coolant), and towards a CDU 1312.

In at least one embodiment, spent second coolant exchanges its heat with a primary coolant in a primary cooling loop 1306 via a CDU 1312. In at least one embodiment, spent second coolant may be renewed (such as relatively cooled when compared to a temperature at a spent second coolant stage) and ready to be cycled back to through a second cooling loop 1308 to one or more computing components. In at least one embodiment, various flow and temperature control features in a CDU 1312 enable control of heat exchanged from spent second coolant or flow of second coolant in and out of a CDU 1312. In at least one embodiment, a CDU 1312 may be also able to control a flow of primary coolant in primary cooling loop 1306.

Even in datacenters 1300 that utilize liquid cooling as described above in connection with Fig. 11, split heat sinks such as the split heat sink 100 may be utilized to facilitate the cooling of high-power components and adjacent or neighboring low-power components, which may advantageously improve the serviceability of the adjacent or neighboring low-power components in particular. Removal of a single section of a split heat sink 100 to service an underlying component is substantially easier than removing, for example, an entire liquid-cooled heat sink or cold plate such as those described in connection with Fig. 11.

In the packaging of integrated circuit (IC) chips, various packaging schemes are employed, including traditional two-dimensional (2D) integrated circuit (IC) packages as well as the more recently introduced 2.5D IC and 3D IC packages. In 2D IC packages, multiple chips are mounted on a printed circuit board, where high-performance logic, lower-performance logic, memory, and analog/RF functions, and other functional elements are presented as discrete devices in separate chip packages. By contrast, in 2.5D ICs and 3D IC packages, multiple IC chips are mounted on a silicon interposer instead of a conventional package substrate. The silicon interposer, which is typically a silicon wafer, allows very small and high-density conductive traces to be formed between the multiple IC chips because the fabrication processes used to form the conductive traces are the same processes used to form the metal interconnects in the metalization layers of a silicon chip.

Compared to 2.5D IC packages and 3D IC packages, a circuit board with individually packaged chips, such as a 2D IC package, has numerous disadvantages. For example, a 2D IC package is generally larger, heavier, consumes more power, and, because the signals propagate relatively slowly across the circuit board from one chip to another, is slower than an equivalent 2.5D or 3D IC package. Furthermore, a 2D IC package has more possible points of failure, given that the soldered joints on the circuit board are more likely to fail than the electrical connections formed within an interposer. That said, troubleshooting a 2D IC package after the different chips have been mounted on the circuit board is relatively straightforward. In particular, the conductive traces carrying I/O signals between the various chips on the circuit board are easily accessible and therefore can be employed to measure specific I/O signals during troubleshooting.

By contrast, troubleshooting a 2.5D or 3D IC package is far more problematic because the I/O signals transmitted between the different chips typically are embedded in the silicon interposer and are not physically accessible. Furthermore, because 2.5D and 3D IC packages are high-bandwidth and are quite dense, typically implementations can include thousands of conductive traces routed between the different chips. One example of such an implementation is a memory bus residing in between a processor and a high-bandwidth memory chip. In such implementations, even if the traces could be physically accessed through the silicon interposer with a probe, the accurate and reliable selection of a specific conductive trace or combination of conductive traces for the purpose of troubleshooting the IC package would be very difficult, if not impossible.

In at least one embodiment, one or more parallel processor(s) (such as the parallel processing units 1014 of the parallel processing system 1012) incorporate circuitry optimized for graphics and video processing, including, for example, video output circuitry, and constitutes a graphics processing unit ("GPU"). In at least one embodiment, one or more parallel processor(s) incorporate circuitry optimized for general purpose processing. In at least embodiment, components of computing system (such as the computer system 1000) may be integrated with one or more other system elements on a single integrated circuit. For example, in at least one embodiment, one or more parallel processor(s), a memory hub (such as the main memory 1004 of the computer system 1000), one or more processor(s) (such as the CPU 1002 of the computer system 1000), and an I/O hub (which may facilitate communication with, for example, one or more display devices 1006, one or more input devices 1008, and/or a network interface 1022 of a system such as the computer system 1000) can be integrated into a system on chip (SoC) integrated circuit. In at least one embodiment, components of such a computing system can be integrated into a single package to form a system in package ("SIP") configuration. In at least one embodiment, at least a portion of components of such a computing system can be integrated into a multi-chip module ("MCM"), which can be interconnected with other multi-chip modules into a modular computing system. In at least one embodiment, an I/O subsystem and any display devices are omitted from such a computing system .

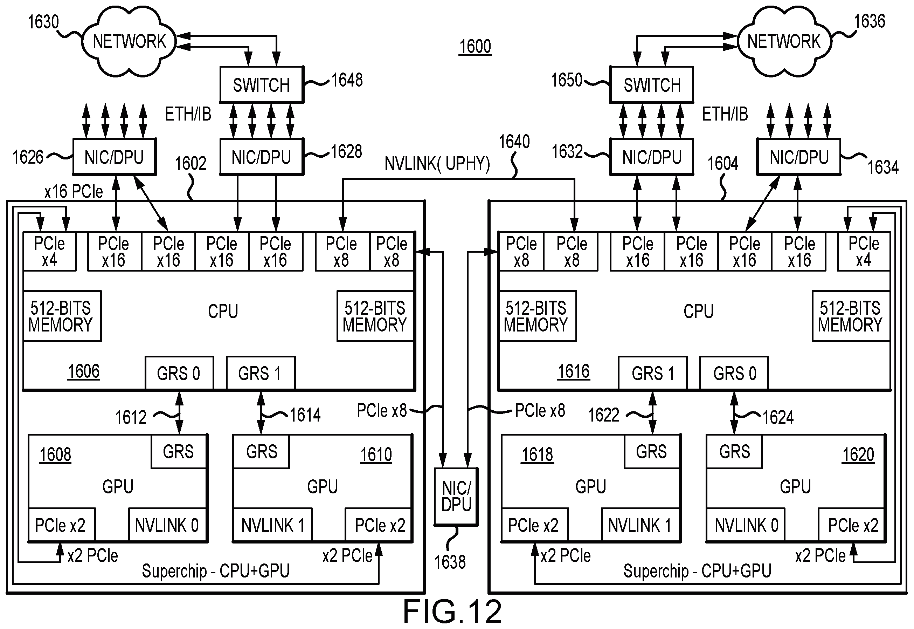

Fig. 12 is a block diagram that schematically illustrates a computing system 1600, e.g., a data center or a High-Performance Computing (HPC) cluster, in accordance with an embodiment that is described herein. System 1600 comprises a plurality of subsystems, e.g. multiple processing devices coupled to each other, multiple network devices, and multiple networks, according to at least one embodiment. Computing system 1600 is designed with multiple integrated circuits (referred to as processing devices), where each integrated circuit can include one or more CPUs and GPUs, forming a powerful and flexible architecture.

The various processing devices are interconnected via an NVLink or other high-speed interconnect, enabling high-speed communication between the subsystems, and are also connected through a NIC or DPU to ensure efficient data transfer across computing system 1600 and to one or more external networks 1630, 1636. In the present example, system 1600 comprises a packet switch 1648 that connects NIC/DPU 1628 to network 1630, and a packet switch 1650 that connects NIC/DPU 1632 to network 1636.

The coupling of processing devices through NVLink allows for seamless data exchange and parallel processing, enhancing overall computational performance. The processing devices are connected to multiple networks through one or more network interface controllers (NICs) or DPUs, enabling the system to handle complex, multi-network tasks with high bandwidth and low latency. This configuration is highly suitable for demanding applications that require significant processing power, such as artificial intelligence (AI), machine learning (ML), and data-intensive computing, while ensuring robust connectivity and scalability across various networked environments. The integrated circuits of the computing system 1600 can include one or more CPUs and one or more GPUs.

Fig. 12 also demonstrates an example architecture of a multi-GPU architecture. As illustrated in the figure, computing system 1600 includes a processing device 1602 with a multi-GPU architecture. In particular, processing device 1602 may be a system-on-chip and includes multiple subsystems such as a CPU 1606, a GPU 1608, and a GPU 1610. CPU 1606 can be coupled to GPU 1608 via a die-to-die (D2D) or chip-to-chip (C2C) interconnect 1612, such as a Ground-Referenced Signaling interconnect (GRS interconnect). CPU 1606 can be coupled to GPU 1610 via a D2D or C2C interconnect 1614. CPU 1606 can also couple to GPU 1608 and GPU 1610 via PCIe interconnects.

CPU 1606 can be coupled to one or more NICs or DPUs, which are coupled to one or more networks. For example, as illustrated in Fig. 12, CPU 1606 is coupled to a first NIC/DPU 1626, which is coupled to a network 1630. CPU 1606 is also coupled to a second NIC/DPU 1628, which is coupled to network 1630 via switch 1648. NIC/DPU 1626 and NIC/DPU 1628 can be coupled to network 1630 over Ethernet (ETH), NVLINK or InfiniBand (IB) connections, for example.

Computing system 1600 also includes a processing device 1604 with a multi-GPU architecture. In particular, processing device 1604 includes multiple subsystems including a CPU 1616, a GPU 1618, and a GPU 1620. CPU 1616 can be coupled to GPU 1618 via an D2D or C2C interconnect 1622. CPU 1616 can be coupled to GPU 1620 via a D2D or C2C interconnect 1624. CPU 1616 can also couple to GPU 1618 and GPU 1620 via PCIe interconnects. CPU 1616 can be coupled to one or more NICs or DPUs, which are coupled to one or more networks. For example, as illustrated in Fig. 12, CPU 1616 is coupled to a first NIC/DPU 1632, which is coupled to a network 1636. CPU 1616 is also coupled to a second NIC/DPU 1634, which is coupled to network 1636 via switch 1650. NIC/DPU 1632 and NIC/DPU 1634 can be coupled to network 1636 over Ethernet (ETH), NVLINK or InfiniBand (IB) connections.

In at least one embodiment, processing device 1602 and processing device 1604 can communicate with each other via a NIC/DPU 1638, such as over PCIe interconnects. Processing device 1602 and processing device 1604 can also communicate with each other over high-bandwidth communication interconnects 1640, such as an NVLink interconnect or other high-speed interconnects. The packet switches in Fig. 12 may comprise, for example, Nvidia Quantum-2 switches. The NICs/DPUs in the figure may comprise, for example, Nvidia Bluefield DPUs.

Cooling systems such as the system 100 described herein may be utilized to cool one or more of the components of the system 1600. For example, such a cooling system may be used to cool one or more of the CPUs 1606 and 1616, one or more of the GPUs 1608, 1610, 1618, and 1620, the entire superchip comprising the CPU 1606 and the GPUs 1608 and 1610, and/or comprising the CPU 1616 and the GPUs 1618 and 1620, and or any other physical, heat-producing component of the system 1600.

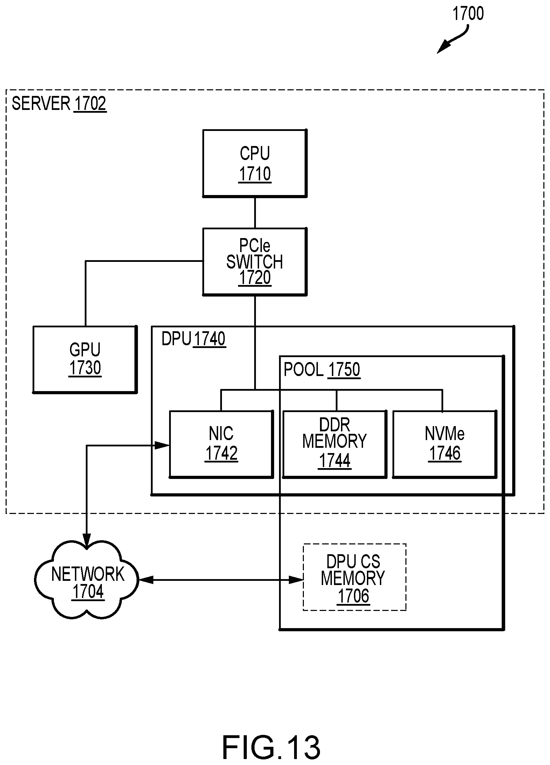

Fig. 13 illustrates an example computing environment 1700 according to at least one embodiment of the present disclosure in which forward pass offloading to available memory can be performed, in accordance with at least one embodiment. It should be appreciated that embodiments of the present disclosure may also be used with reference to alternative environments and that specific discussion of components may be provided by way of non-limiting example and may include equivalents. Moreover, various features have been removed for clarity and conciseness. Additionally, systems and methods may be used with a variety of different architectures. The example computing environment 1700 may include a server 1702 which may be used to perform HPC workloads, such as AI training or machine learning model training. In an embodiment, the server 1702 may be an application instance or a compute node. The server 1702 may include a CPU 1710 associated with a switch 1720, such as a peripheral component interconnect express (PCIe) switch, which may control at least some data transmission over communication paths interconnecting various components. In an embodiment, the CPU 1710 may include a root complex processor.

The PCIe switch 1720 may also be associated with a GPU 1730 and a DPU 1740, and may transmit data between at least some of the CPU 1710, the G7PU 130, the DPU 1740, and other components. In an embodiment, the PCIe switch 1720 may be associated with more than one GPU or more than one DPU. In another embodiment, the PCIe switch 1720 may be located within the DPU 1740. The PCIe switch 1720 may manage the transfer of at least some data between the CPU 1710, the GPU 1730, and the DPU 1740. In another embodiment, the number of GPUs associated with the PCIe switch 1720 may be equal to the number of DPUs associated with the PCIe switch 1720. In at least one embodiment, the server 1702 may include, without limitation, any number of the CPUs 1710, the PCIe switches 1720, the GPUs 1730, and/or the DPUs 1740, in any combination. For example, in at least one embodiment, server 1702 could include eight, sixteen, thirty-two, and/or more GPUs 1730. In at least one embodiment, communication paths interconnecting various components, including but not limited to the CPU 1710, the PCIe switch 1720, the GPU 1730, and the DPU 1740, in Fig. 13 may be implemented using any suitable protocols, such as peripheral component interconnect (PCI) based protocols (e.g., PCIe), or other bus or point-to-point communication interfaces and/or protocol(s), such as NV-Link high-speed interconnect, or interconnect protocols.

The DPU 1740 may include a network interface controller (NIC) 1742, a DDR memory 1744, and a non-volatile memory express (NVMe) device 1746. The NIC 1742 may be able to interface with a network 1704, which may also interface with additional NVMe devices available to the DPU 1740, such as over fabric. In an embodiment, the DPU 1740 may not include the NVMe device 1746. In another embodiment, the NVMe device 1746 may be located on the server 1702 and not on the DPU 1740. In yet another embodiment, the computing environment 1700 may include more than one of the NVMe device 1746, such as a first NVMe device in the DPU 1740 and a second first NVMe device on the server 1702 an associated directly with the PCIe switch 1720. In an embodiment, the DPU 1740 may not include the DDR memory 1744 and may include a computational storage services (CSS) in place of, or in addition to, the DDR memory 1744. For example, the computing environment 1700 may include DPU computational storage (CS) memory 1706 available to the DPU 1740 as part of the CSS. The network 1704 may be able to interface with the DPU CS memory 1706 through the NIC 1742, according to any suitable interface protocol, such as remote direct memory access (RDMA) over Ethernet, InfiniBand, Fiber Channel, etc..

The total memory of the computing environment 1700 available for data storage may be expanded through the use of the DPU 1740 on nodes of the system. The DPU 1740 may have access to a pool 1750 of memory already available to the server 1702, such as double data rate (DDR) memory, on-board NVMe devices, NVMe devices over fabric, and CS. The pool 1750 of memory may include at least one of the DDR memory 1744, NVMe 1746, and the DPU CS memory 1706. The DPU 1740 may also be able to access the available memory of other DPUs as part of the pool 1750, and other DPUs may be able to access the available memory of DPU 1740, such as the pool 1750. This available memory can be accessed and utilized for data storage, without the addition of compute resources, such as compute nodes, which would be required using other solutions. The available pool 1750 accessible to the DPU 1740 may be provisioned for the server 1702 to expand the total memory available for data storage, such as to reduce the data storage load on the CPU 1710 or the GPU 1730, which can instead increase the utilization of their memory for processing. For example, during training of an AI, the model states, residual states, activation functions, and checkpoints can be stored, or offloaded, on the pool 1750 accessible to the DPU 1740.

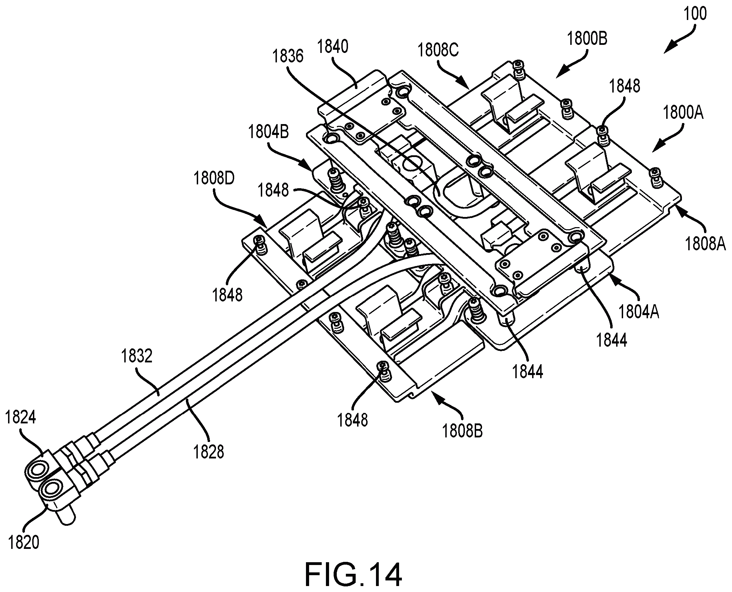

As noted above, the system 100 may be configured to support air cooling and/or liquid cooling approaches. With general reference to Figs. 14-24 and specific reference to Figs. 14, 15, and 16, the system 100, which may be referred to as a liquid-cooled system or as a liquid-cooled heat sink, is shown to include a first split heat sink assembly 1800A and a second split heat sink assembly 1800B. The split heat sink assemblies 1800A, 1800B may be collectively cooled with a cooling fluid provided by a fluid inlet 1820. As will be discussed in further detail herein, each split heat sink assembly 1800A, 1800B may have sections that are directly cooled by a cooling fluid and other sections that are indirectly cooled by a cooling fluid (e.g., by virtue of being thermally coupled with a section that is directly cooled by a cooling fluid).

The system 100 is further shown to include a fluid outlet 1824 that receives cooling fluid after such cooling fluid as passed through the first split heat sink assembly 1800A and the second split heat sink assembly 1800B. In some embodiments, a first inlet tube 1828 may carry a cooling fluid from the fluid inlet 1820 to a first central heat sink 1804A, which may also be referred to as a first heat sink section of the first split heat sink assembly 1800A. The cooling fluid may enter the first central heat sink 1804A at a first chamber 1904A then travel through a cold plate assembly of the first central heat sink 1804A.

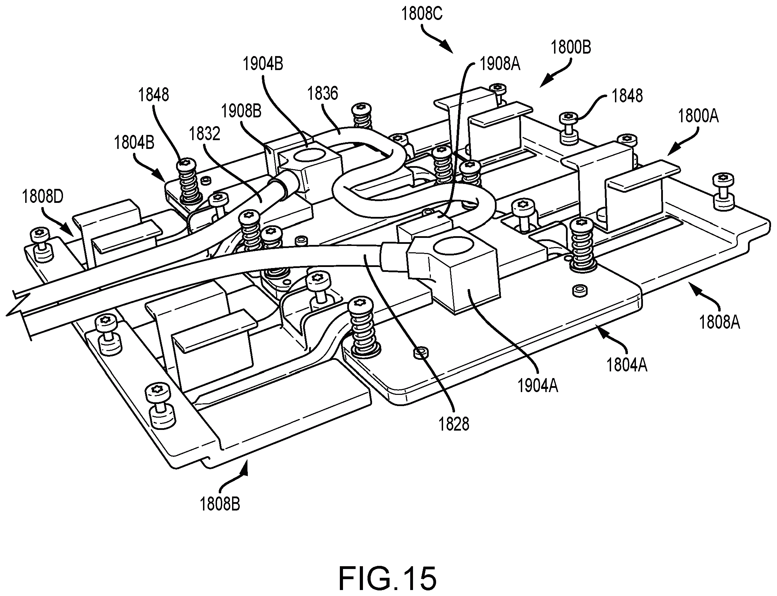

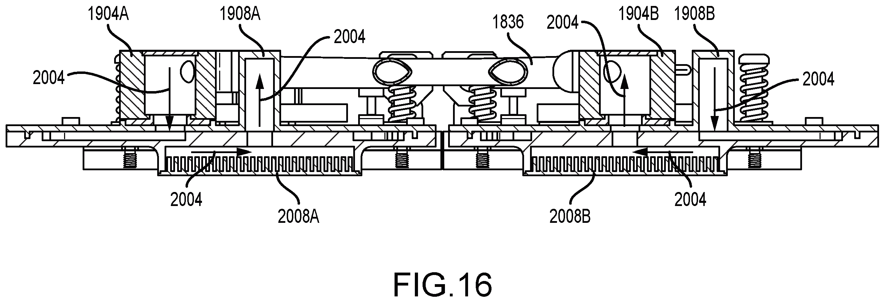

As can be seen in Figs. 15 and 16, the cooling fluid entering the first chamber 1904A may follow a fluid flow path/channel 2004 into the first cold plate assembly of the first central heat sink 1804A. The cooling fluid may then flow away from the first cold plate assembly of the first central heat sink 1804A at a first coupling manifold 1908A. The first coupling manifold 1908A may be fluidically coupled with a second coupling manifold 1908B, which is part of a second cold plate assembly of the second central heat sink 1804B. The cooling fluid may then flow through the cold plate assembly of the second central heat sink 1804B. After flowing through the cold plate assembly of the second central heat sink 1804B, the cooling fluid may exit at a second chamber 1904B and then be carried to the fluid outlet 1824 via an outlet tube 1832.

In some embodiments, the first and second central heat sinks 1804A, 1804B are thermally coupled with a heat-generating component, such as a high-power component. Because the central heat sinks 1804A, 1804B are directly cooled by the cooling fluid, the efficiency with which the central heat sinks 1804A, 1804B are allowed to extract heat from the high-power component is significantly increased as compared to a heat sink section that is not directly cooled with a cooling fluid.

It should be appreciated that the tubes 1820, 1824, 136 may be connected to their respective parts of the heat sink using any suitable connection mechanism. In some embodiments, an o-ring may be used to seal the connection between a tube 1820, 1824, 1836 and the element in which the tube 1820, 1824, 1832 is inserted/connected. Such a connection may facilitate a relatively flexible design where the tubes 1820, 1824, 1836 are allowed to swivel and/or move up and down for relatively easy servicing access. Utilization of one or more o-rings may benefit from utilization of a leak detection sensor at or near the point where the o-ring is provided. For instance, a leak detection sensor may be incorporated into one of the tubes near the o-ring or may be inserted in line between the tube and the o-ring to help quickly detect a leak at the o-ring. As another design alternative to flexible tubes and o-rings, it may also be possible to utilize stiffer tubes and connect those tubes to an appropriate element using more secure mechanisms (e.g., brazing, soldering, etc.).

In some embodiments, the cooling fluid may be routed through the split heat sink assemblies 1800A, 1800B in a manner that help cool all elements as efficiently as possible. As a non-limiting example, cooling fluid may first be routed to portions of the split heat sink assemblies 1800A, 1800B that are thermally coupled with a low-power component first. The cooling fluid may then be routed to cool the high-power component. Taking this sequential routing logic helps to protect the low-power component (e.g., memory) from heat generated at the high-power component (e.g., the CPU).

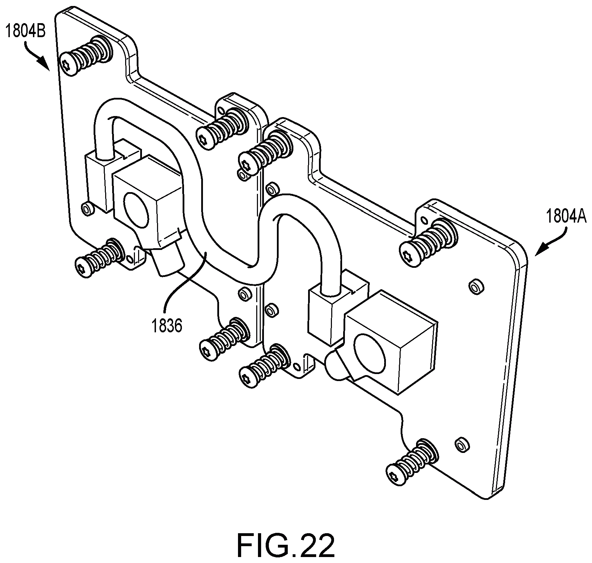

As can be seen in Fig. 22, the coupling tube 1836 may provide a fluidic connection between the first central heat sink 1804A and the second central heat sink 1804B. The coupling tube 1836 may be formed in a serpentine shape to accommodate a flexible connectivity between the central heat sinks 1804A, 1804B. Said another way, the shape of the coupling tube 1836 may be created to enable connectivity between the central heat sinks 1804A, 1804B that does not rely on precise machining tolerances between the central heat sinks 1804A, 1804B. Thus, the mounting/positioning of one central heat sink (e.g., the first central heat sink 1804A) in the context of the system 100 does not directly dictate a precise mounting/positioning of the other central heat sink (e.g., the second central heat sink 1804B). The serpentine shape of the coupling tube 1836 may allow variances in mounting heights and distances between the central heat sinks 1804A, 1804B. In some embodiments, the coupling tube 1836 may be made of metal, such as copper, and may be brazed to the coupling manifolds 1908A, 1908B to provide a fluidic seal between the coupling tube 1836 and each of the coupling manifolds 1908A, 1908B. Alternatively, the coupling tube 1836 may be constructed of a rigid or semi-rigid plastic (e.g., Polyvinyl Chloride (PVC), High-Density Polyethylene (HDPE), Nylon, and engineered plastics like PEEK or PVDF, in which case the coupling tube 1836 may be secured to the coupling manifolds 1908A, 1908B with an adhesive, friction fitting, or the like. The inlet tube 1828 and outlet tube 1832 may also be constructed of metal, plastic, or similar materials used for the coupling tube 1836. In some embodiments, materials selected for the tubes 1828, 1832, and/or 1836 may be selected to ensure that cooling fluid is allowed to pass through components of the system 100 at pressures of 15 PSI or more.

Fig. 14 further illustrates that a handle 1840 may be used to couple the first central heat sink 1804A with the second central heat sink 1804B. The handle 1840 may correspond to a rigid or semi-rigid structure that can be connected to both of the central heat sinks 1804A, 1804B with one or more risers or standoffs 1844. The handle 1840, in some embodiments, can be used to carry or maneuver the components of the system 100 (e.g., for purposes of moving the system 100, for purposes of installing the system 100, and/or for purposes of physically adjusting a position of the system 100). The handle 1840 may represent a more rigid coupling between the central heat sinks 1804A, 1804B as compared to the coupling tube 1836. The handle 1840 and the standoffs 1844 may be constructed of metal, plastic, or materials similar to that used in the tube(s) 1828, 1832, 1836.

With general reference to Figs. 14-24, and with more specific reference to Figs. 14, 15, 17, and 21, additional details of the modularity of the split heat sink assemblies 1800A, 1800B will be described in accordance with at least some embodiments of the present disclosure. Each split heat sink assembly 1800 may include the central heat sink section and a plurality of side wing heat sinks 1808. As a non-limiting example, the first central heat sink 1804A is shown to have a first side wing heat sink 1808A and a second side wing heat sink 1808B connected thereto. In some embodiments, each of the first side wing heat sink 1808A and the second side wing heat sink 1808B may be connected with the first central heat sink 1804A using at least one screw 1848. In some embodiments, each of the first side wing heat sink 1808A and the second side wing heat sink 1808B may be attachable to and detachable from the first central heat sink 1804A. The attachability and detachability of the side wing heat sinks 1808A, 1808B may facilitate a modular servicing of components underneath one of the sections (e.g., underneath a side wing heat sink 1808A, 1808B) without requiring the removal from the other section (e.g., the first central heat sink 1804A) from the heat-generating component underneath the first central heat sink 1804A.

Simila to the first split heat sink assembly 1800A, the second split heat sink assembly 1800B may have a collection of modular elements. The second central heat sink 1804B is shown to have a third side wing heat sink 1808C and a fourth side wing heat sink 1808D connected thereto. In some embodiments, each of the third side wing heat sink 1808C and the fourth side wing heat sink 1808D may be connected with the second central heat sink 1804B using at least one screw 1848. In some embodiments, each of the third side wing heat sink 1808B and the fourth side wing heat sink 1808D may be attachable to and detachable from the second central heat sink 1804B. The attachability and detachability of the side wing heat sinks 1808C, 1808D may facilitate a modular servicing of components underneath one of the sections (e.g., underneath a side wing heat sink 1808C, 1808D) without requiring the removal from the other section (e.g., the second central heat sink 1804B) from the heat-generating component underneath the second central heat sink 1804B.

In addition to having a physical connection between the side wing heat sink 1808 and the central heat sink 1804, a thermal connection may be established therebetween. In some embodiments, each side wing heat sink 1808 may include one or more heat pipes 2108 that transfer heat between side wing heat sink 1808 and the central heat sink 1804. The heat pipe(s) 2108 may travel between a thermal coupling 2104 and lower section 2504 of the side wing heat sink 1808. The lower surface of the thermal coupling 2104 may rest upon or physically contact a top surface of a central heat sink 1804 to help establish a thermal connection between the components. At least one screw 1848 may help secure the physical connection between the side wing heat sink 1808 and the central heat sink 1804.

One or more additional screws 1848 may be provided on a mounting ledge 2508 of the side wing heat sink 1808. The additional screws 1848 provided on the mounting ledge 2508 may be configured to connect the side wing heat sink 1808 to an underlying substrate or board on which heat-generating components (e.g., high-power components and/or low-components) are mounted. By securing the side wing heat sink 1808 to an underlying substrate or board, a direct thermal connection can be made between a bottom surface of the lower section 2504 and a top surface of a heat-generating component (e.g., a low-power component).

In some embodiments, the side wing heat sink 1808 may be easily and safely removable from the central heat sink 1804 without requiring removal of the central heat sink 1804 from the substrate or board on which it is mounted. As an example, after the screws coupling the two sections of the heat sink have been removed, the side wing heat sink 1808 may be easily removed from the central heat sink 1804 by a relatively simple set of sliding motions. The sections of the heat sink may be constructed with sufficient mechanical clearances to allow removal of the heat spreader using a first back sliding motion and a second sideways sliding motion. As a more specific but non-limiting configuration, a "slide back and to the left" motion may be utilized to extract the side wing heat sink 1808 from central heat sink 1804. In some embodiments, the side wing heat sink 1808 may further include one or more handles or brackets mounted to an upper surface thereof to facilitate a user's grip and to make the sliding removal motions more easily applied to the side wing heat sink 1808.

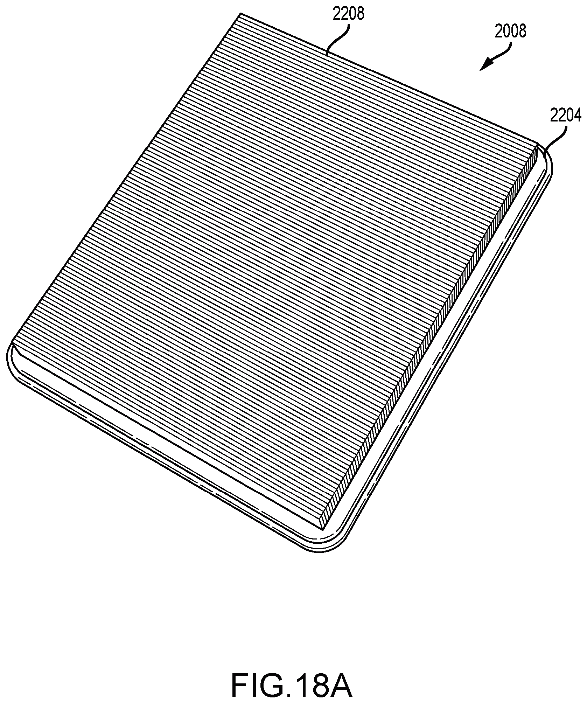

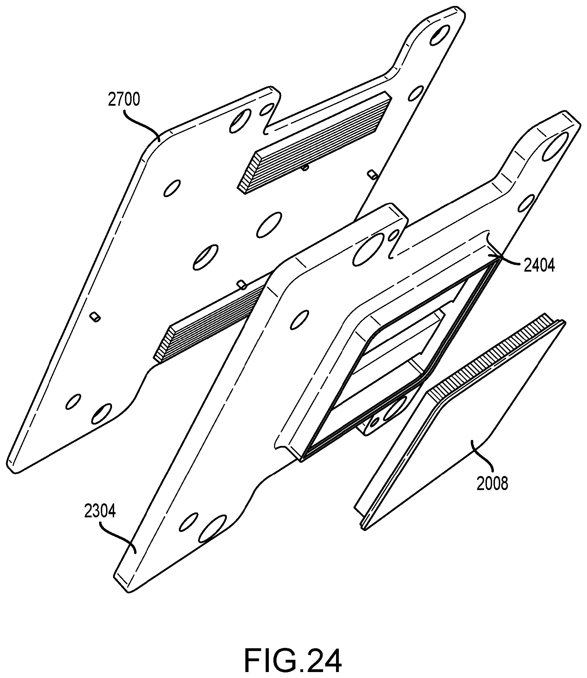

With reference now to Figs. 18A - 18B and 23A - 24, additional details of a liquid-cooled cold plate or cold plate assembly will be described in accordance with at least some embodiments of the present disclosure. As seen in Fig. 24, the liquid-cooled cold plate may include a cold plate thermal contact 2008, a cold plate body 2304, and a cold plate cover 2700. The cold plate thermal contact 2008 may fit within a pedestal 2404 that is formed on a first side of the cold plate body 2304. A second side of the cold plate body 2304 (e.g., that opposes the first side thereof) may mate with the cold plate cover 2700. In this way, the cold plate body 2304 is configured to be positioned between the cold plate thermal contact 2008 and the cold plate cover 2700. One, some, or all of the components of the liquid-cooled cold plate may be constructed of metal or a similar type of thermally-conductive material. The liquid-cooled cold plate may be configured to extract heat from a heat-generating component (e.g., a high-power component) that is physically contacting the cold plate thermal contact 2008.

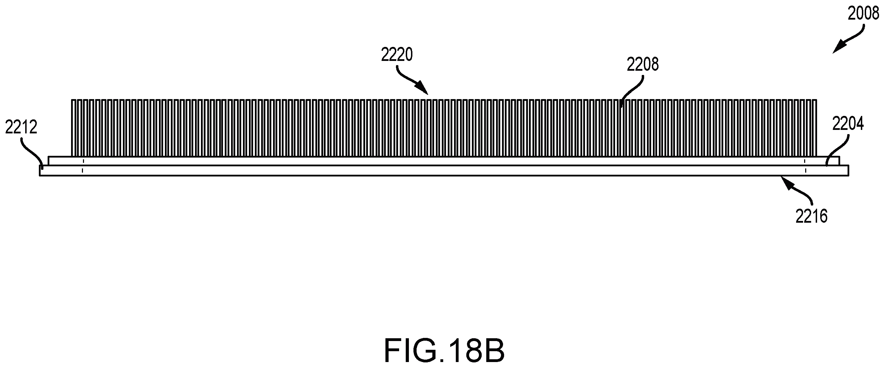

As shown in Figs. 18A and 18B, the cold plate thermal contact 2008 may include a first side 2216 and a second side 2220. The first side 2216 may be configured to contact the heat-generating component, either directly or indirectly (e.g., with a TIM provided therebetween). The second side 2220 may have a plurality of cooling fins 2208 formed thereon. The cooling fins 2208 may be skived, machined, extruded, or otherwise formed in the second side 2220 of the cold plate thermal contact 2008. In some embodiments, forming the cooling fins 2208 with a skiving process may enable the establishment of substantially uniform fins across the second side 2220. Skiving can be used to create a high-performance, single-piece cold plate thermal contact 2008 by shaving and lifting thin layers of metal (e.g., aluminum or copper) from a solid base using a precise, specialized blade. A skiving process can help create dense, thin fins 2208 that are part of the cold plate thermal contact 2008, eliminating thermal interface resistance and offering significantly improved thermal conductivity as compared to an extruded heat sink. It should be appreciated, however, that the fins 2208 can be formed using extrusion without departing from the scope of the present disclosure.

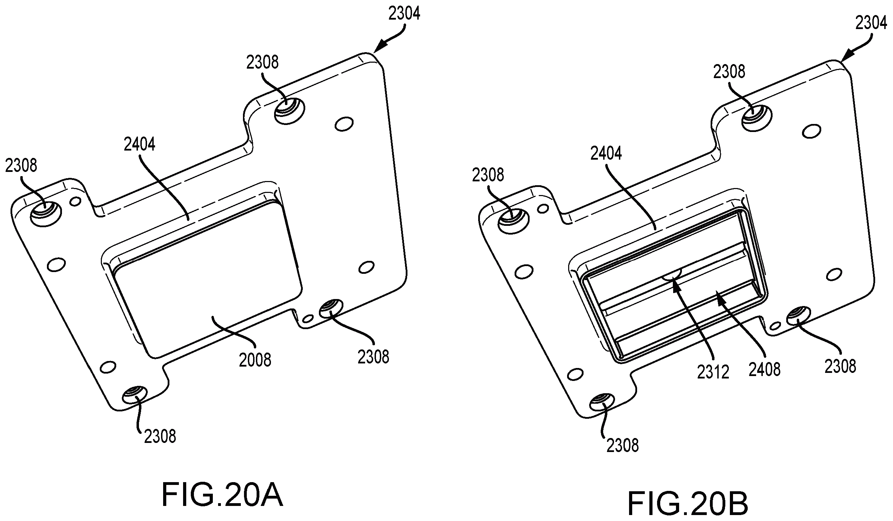

The cold plate thermal contact 2008 also include a lip 2204 having an edge 2212 that seals with a corresponding lip of the pedestal 2404. As shown in Figs. 20A and 20B, the cold plate body 2304 is shown to include the pedestal 2404, which simultaneously forms a feature into which the cold plate thermal contact 2008 can mate as well as forming a fluid cavity 2408 for a cooling fluid to flow. More specifically, the cold plate body 2304 is shown to include a fluid hole 2312 within the area defined by the pedestal 2404. The fluid flow 2004 may travel through the fluid cavity 2408 across the fins 2208 of the cold plate thermal contact 2008. The cooling fluid may enter and/or exit the fluid cavity 2408 via the fluid hole 2312. While the cold plate body 2304 is shown to have a single fluid hole 2312, it should be appreciated that more than one fluid hole 2312 may be provided in the cold plate body 2304 without departing from the scope of the present disclosure.

The cold plate body 2304 may also include a number of mounting holes 2308 that can be used to accept screws, bolts, or other suitable fasteners that help secure the components of the cold plate together and that help secure the cold plate to an underlying substrate or board. In some embodiments, the cold plate cover 2700 may have a plurality of complimentary mounting holes 2308 that substantially align with the mounting holes 2308 of the cold plate body 2304. In this way, a screw 1848 or similar fastener may travel through the aligned mounting holes 2308 to secure the cold plate to the substrate or board.

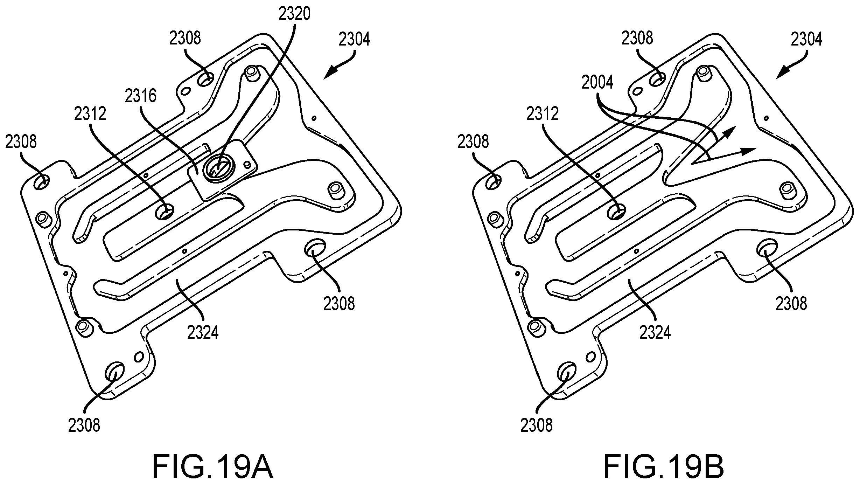

As shown in Figs. 19A and 19B, the cold plate body 2304 may also have a flow channel 2324 established on a side that faces toward the cold plate cover 2700. The flow channel 2700 may help define and maintain the fluid flow 2004 through the cold plate. In some embodiments, the flow channel 2324 may traverse a substantial portion of the cold plate body 2304 (e.g., more than 50% thereof) to help define the path for the fluid flow 2004 across the thermally conductive material of the cold plate body 2304. Establishing an extended flow channel 2324 helps to increase the thermal performance of the liquid-cooled cold plate. In some embodiments, the flow channel 2324 may be formed as a trench, depression, or series of recesses in the side of the cold plate body 2304 that faces toward the cold plate cover 2700.

The cold plate cover 2700 may help to seal the flow channel 2324 while also providing a location where cooling fluid can enter and exit the flow channel 2324. Specifically, the cold plate cover 2700 may be brazed or otherwise connected to the cold plate body 2304 to press a first face 2716 of the cold plate cover 2700 onto the side of the cold plate body 2304 that faces toward the cold plate cover 2700. The cold plate cover 2700 may also include a fluid hole 2712 that provides a passage between the chamber 1904 to which a fluid tube 1828, 1832 is connected. Around the fluid hole 2712 the cold plate cover 2700 may also have a ridge 2704 that provides a mating feature for the chamber 1904. Additionally, a seal 2316 may be provided between the cold plate cover 2700 and the cold plate body 2304 in substantial alignment with the fluid hole 2712. The seal 2316 may mate with the ridge 2704 to maintain a fluidic seal between the cold plate cover 2700 and the chamber 1904. In the depicted embodiment, the chamber 1904 is provided as a separate component from the cold plate cover 2700.

The cold plate cover 2700 may further include the coupling manifold 1908 formed therein. In some embodiments, the cold plate cover 2700 may be machined, molded, or otherwise formed to include the coupling manifold 1908 as an integral component thereof. The coupling manifold 1908 and the ridge 2704 are both shown to be on the second face 2720 of the cold plate cover 2700 whereas the first face 2716 of the cold plate cover 2700 may couple with the cold plate body 2304. In some embodiments, the first face 2716 of the cold plate cover 2700 may also include a plurality of fins 2708 formed therein. The fins 2708 may be formed in a similar fashion to fins 2208. In some embodiments, the fins 2708 may extend from the first face 2716 down into the flow channel 2324 to help increase the thermal communication between the cold plate and the cooling fluid flowing therethrough. One, some, or all components of the cold plate assembly (e.g., the cold plate thermal contact 2008, the cold plate body 2304, and/or the cold plate cover 2700) may be formed of a metal or similar thermally-conductive material. The cold plate assembly represents a significant portion of the central heat sink 1804A or 1804B that is cooling a heat-generating component (e.g., a high-power component) in thermal communication therewith. The cold plate assembly may also include a number of mounting holes that facilitate connectivity with a substrate or board and that further facilitate a modular connection with one or more side wing heat sinks 1808A, 1808B, 1808C, 1808D. As further noted above, the second face 2720 of the cold plate cover 2700 may have a thermal coupling 2104 of a side wing heat sink resting thereon, which may include a heat pipe 2108 routed therethrough. Heat may flow between the cold plate assembly and the side wing heat sink thermally coupled therewith via the heat pipe(s) 2108 to facilitate an efficient transfer of heat away from heat-generating components mounted underneath the central heat sink and heat-generating components mounted underneath the side wing heat sinks.

In some embodiments, the configuration of flow channels 2324, manifolds 1908, and other elements of the cold plate assembly may be formed to ensure that heat generated at one component being cooled does not inadvertently damage another component of the system. For instance, the cold plate body 2304 and manifolds 1908 may be configured in either a parallel configuration or a series configuration. Continuing the example, use of a parallel configuration, use of parallel flows before or within the cold plate body 2304, and/or use of a flow channel 2324 having a splitter manifold can help in low-flow scenarios where series routing causes too much pre-heat. In some embodiments, the manifolds 1908 may be configured to route two separate fluid flow paths from each of the side wing heat sinks 1808A, 1808B, 1808C, 1808D and combine the two separate fluid flow paths (e.g., from two different tubes) into a single fluid flow that is combined and provided to the central heat sink 1804 and the cold plate body 2304 included therein. In embodiments where the side wing heat sinks 1808A, 1808B, 1808C, 1808D receive cooling first, the system 100 may be designed to be thermally forgiving enough to allow thicker and more compliant materials to be used (e.g., the system 100 can accommodate larger height tolerances between components).

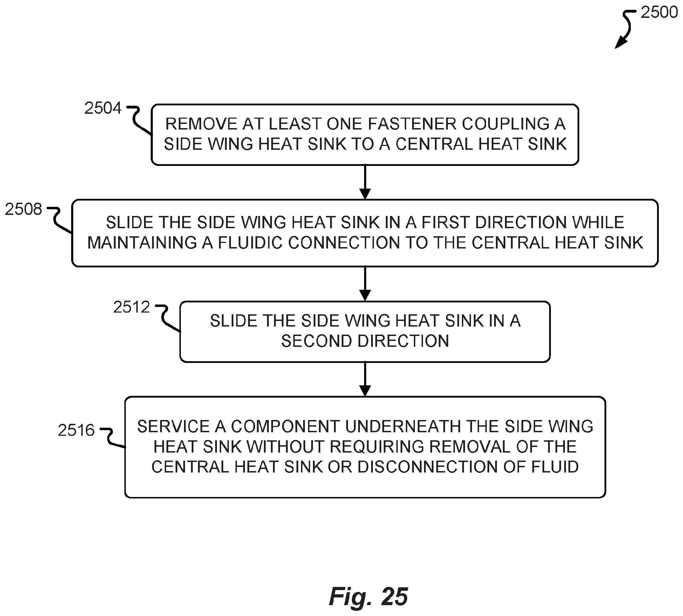

With reference now to Fig. 25, a method 2500 of servicing a system 100 will be described in accordance with at least some embodiments. The method 2500 may include physically disconnecting a side wing heat sink 1808 from a central heat sink 1804 to allow access to a component under one of the sections without requiring both sections to be removed from the substrate or board on which they are mounted. The side wing heat sink 1808 may be disconnected from the central heat sink 1804 by removing at least one fastener that couples the side wing heat sink 1808 (step 2504). In some embodiments, the fastener may correspond to a screw 1848, multiple screws, or the like.

Once the fastener used to physically couple the heat sink sections has been removed, the method 2500 may continue by sliding the side wing heat sink 1808 in a first direction without requiring movement of the central heat sink 1804 (step 2508). As an example, the side wing heat sink 1808 may be slid in a backwards direction relative to the central heat sink 1804 while a fluidic connection is maintained between the central heat sink 1804 and the tube(s) that provide cooling fluid thereto.

The method 2500 may further include a step where the side wing heat sink 1808 is slid in a second direction (step 2512). As an example, after the side wing heat sink 1808 is slid in a first direction (e.g., backwards), the side wing heat sink 1808 may be slid in a second direction that is different or orthogonal to the first direction (e.g., right or left).

After the side wing heat sink 1808 has been appropriately slid to decouple the side wing heat sink 1808 from the central heat sink 1804, the side wing heat sink 1808 may be removed from the system 100 to expose a component underneath, thereby enabling servicing of the component without requiring removal of the central heat sink 1804 (step 2516). Thus, components underneath portions of one heat sink section (e.g., the central heat sink 1804) may be left in place while other components underneath other portions of a different heat sink section (e.g. the side wing heat sink 1808) may be accessed for maintenance.

Embodiments of the present disclosure may comprise any suitable material known in the art (e.g., carbon steel, aluminum, polymers, ceramics, and the like), particularly materials possessing high thermal conductivity. By way of example, components as described herein may be created by an extrusion and/or machine process. In such an example, a single body of fixed cross-sectional area may be produced by an extrusion process.

Many modifications and other embodiments of the disclosures set forth herein will come to mind to one skilled in the art to which these disclosures pertain having the benefit of teachings presented in the foregoing descriptions and the associated drawings. Although the figures only show certain components of the apparatus and systems described herein, it is understood that various other components (e.g., components of printed circuit boards, transceivers, cables, etc.) may be used in conjunction with components described herein. Therefore, it is to be understood that the disclosures are not to be limited to the specific embodiments disclosed and that modifications and other embodiments are intended to be included within the scope of the appended claims.

It is to be appreciated that any feature described herein can be claimed in combination with any other feature(s) as described herein, regardless of whether the features come from the same described embodiment.

Specific details were given in the description to provide a thorough understanding of the embodiments. However, it will be understood by one of ordinary skill in the art that the embodiments may be practiced without these specific details. In other instances, well-known circuits, processes, algorithms, structures, and techniques may be shown without unnecessary detail in order to avoid obscuring the embodiments.

While illustrative embodiments of the disclosure have been described in detail herein, it is to be understood that the inventive concepts may be otherwise variously embodied and employed, and that the appended claims are intended to be construed to include such variations, except as limited by the prior art.

It will be understood that aspects and embodiments are described above purely by way of example, and that modifications of detail can be made within the scope of the claims.

Each apparatus, method, and feature disclosed in the description, and (where appropriate) the claims and drawings may be provided independently or in any appropriate combination.

Reference numerals appearing in the claims are by way of illustration only and shall have no limiting effect on the scope of the claims.

The disclosure of this application also includes the following numbered clauses:
Clause 1. A heat sink, comprising:
   a first section to extract heat generated by a high-power component; and
   at least a second section, attachable to and detachable from the first section, to extract heat generated by a low-power component, wherein the at least a second section, when attached to the first section, is thermally coupled to the first section such that the heat generated by the high-power component is further dissipated by the at least a second section.
Clause 2. The heat sink of clause 1, wherein a flow channel to carry a cooling fluid is provided between the first section and the high-power component.
Clause 3. The heat sink of clause 2, wherein the first section comprises a cold plate assembly having a cold plate body, a cold plate cover, and a cold plate thermal contact, wherein the cold plate body is positioned between the cold plate cover and the cold plate thermal contact, and wherein the flow channel passes between the cold plate body and the cold plate thermal contact to allow heat generated by the high-power component to be transferred to the cooling fluid via the cold plate thermal contact.
Clause 4. The heat sink of clause 3, wherein the cold plate thermal contact comprises a plurality of fins and wherein the cooling fluid flows across the plurality of fins.
Clause 5. A system, comprising:
   a processing unit;
   a first memory module;
   a first heat sink section to extract heat generated by the processing unit; and
   a second heat sink section to extract heat generated by the first memory module, wherein the second heat sink section is attachable to and detachable from the first heat sink section, and wherein the first and second heat sink sections, when attached, collectively transfer heat from the processing unit.
Clause 6. The system of clause 5, further comprising:
   a Printed Circuit Board (PCB) that is attached to both the processing unit and the first memory module.
Clause 7. The system of clause 6, wherein the PCB carries electrical signals between the processing unit and the first memory module.
Clause 8. The system of clause 5, further comprising:
   a second memory module; and
   a third heat sink section to extract heat generated by the second memory module, wherein the third heat sink section is attachable to and detachable from the first heat sink section, and wherein the first and third heat sink sections, when attached, collectively transfer heat from the processing unit.
Clause 9. The system of clause 5, wherein the first memory module is serviceable by detaching the first heat sink section from the second heat sink section.
Clause 10. The system of clause 5, further comprising:
   a stiffener base that provides structural support for the first heat sink section and that provides a connection interface between the first heat sink section and the second heat sink section.
Clause 11. The system of clause 10, further comprising:
   a Thermal Interface Material (TIM).
Clause 12. The system of clause 11, wherein the TIM is provided between the stiffener base and the second heat sink section or between the second heat sink section and the first memory module, wherein the TIM comprises at least one of a grease, a gap pad, a phase change material, and a putty, wherein the TIM provides a substantially uniform cooling between the stiffener base, the first heat sink section, and/or the second heat sink section, and wherein the TIM accommodates a tolerance difference between the stiffener base, the first heat sink section, the second heat sink section, the processing unit, and/or the memory module.
Clause 13. The system of clause 5, further comprising:
   a fluid inlet;
   a fluid outlet;
   an inlet tube that carries a cooling fluid between the fluid inlet and the first heat sink section; and
   a flow channel contained within the first heat sink section, wherein the cooling fluid flows through the flow channel to extract the heat generated by the processing unit.
Clause 14. The system of clause 5, wherein the first heat sink section is liquid-cooled.
Clause 15. The system of clause 5, wherein the first heat sink section is air-cooled.
Clause 16. A system, comprising:
   a first split heat sink assembly, comprising:
      a first central heat sink that is liquid-cooled; and
      at least one side wing heat sink that is thermally coupled with the first central heat sink; and
   a second split heat sink assembly, comprising:
      a second central heat sink that is liquid-cooled; and
      at least one additional side wing heat sink that is thermally coupled with the second central heat sink.
Clause 17. The system of clause 16, wherein the first central heat sink is connected with the at least one side wing heat sink with at least a first screw, wherein the second central heat sink is connected with the at least one additional side wing heat sink with at least a second screw, wherein the at least one side wing heat sink is attachable to and detachable from the first central heat sink, and wherein the at least one additional side wing heat sink is attachable to and detachable from the second central heat sink.
Clause 18. The system of clause 17, wherein the first central heat sink is coupled with the second central heat sink by a coupling tube that carries a cooling fluid therebetween.
Clause 19. The system of clause 18, wherein the at least one side wing heat sink is thermally coupled with the first central heat sink by at least a first heat pipe and wherein the at least one additional side wing heat sink is thermally coupled with the second central heat sink by at least a second heat pipe.
Clause 20. The system of clause 16, wherein the first central heat sink extracts heat generated by a first high-power component, wherein the second central heat sink extracts heat generated by a second high-power component, wherein the at least one side wing heat sink extracts heat generated by a first low-power component, wherein the at least one additional side wing heat sink extracts heat generated by a second low-power component, and wherein a cooling fluid follows a flow path that causes the cooling fluid to encounter the first and second low-power components before encountering the first and second high-power components so as to avoid damaging the first and second low-power components with the heat generated by the first and second high-power components.

## Claims

1. A heat sink, comprising:
a first section to extract heat generated by a high-power component; and
at least a second section, attachable to and detachable from the first section, to extract heat generated by a low-power component, wherein the at least a second section, when attached to the first section, is thermally coupled to the first section such that the heat generated by the high-power component is further dissipated by the at least a second section.

2. The heat sink of claim 1, wherein a flow channel to carry a cooling fluid is provided between the first section and the high-power component.

3. The heat sink of claim 2, wherein the first section comprises a cold plate assembly having a cold plate body, a cold plate cover, and a cold plate thermal contact, wherein the cold plate body is positioned between the cold plate cover and the cold plate thermal contact, and wherein the flow channel passes between the cold plate body and the cold plate thermal contact to allow heat generated by the high-power component to be transferred to the cooling fluid via the cold plate thermal contact, wherein the cold plate thermal contact comprises a plurality of fins and wherein the cooling fluid flows across the plurality of fins.

4. A system, comprising:
a processing unit;
a first memory module;
a first heat sink section to extract heat generated by the processing unit; and
a second heat sink section to extract heat generated by the first memory module, wherein the second heat sink section is attachable to and detachable from the first heat sink section, and wherein the first and second heat sink sections, when attached, collectively transfer heat from the processing unit.

5. The system of claim 4, further comprising:
a Printed Circuit Board (PCB) that is attached to both the processing unit and the first memory module.

6. The system of claim 5, wherein the PCB carries electrical signals between the processing unit and the first memory module.

7. The system of claim 4, 5, or 6, further comprising:
a second memory module; and
a third heat sink section to extract heat generated by the second memory module, wherein the third heat sink section is attachable to and detachable from the first heat sink section, and wherein the first and third heat sink sections, when attached, collectively transfer heat from the processing unit.

8. The system of any of claims 4-7, wherein the first memory module is serviceable by detaching the first heat sink section from the second heat sink section.

9. The system of any of claims 4-8, further comprising:
a stiffener base that provides structural support for the first heat sink section and that provides a connection interface between the first heat sink section and the second heat sink section, further comprising:
a Thermal Interface Material (TIM), wherein the TIM is provided between the stiffener base and the second heat sink section or between the second heat sink section and the first memory module, wherein the TIM comprises at least one of a grease, a gap pad, a phase change material, and a putty, wherein the TIM provides a substantially uniform cooling between the stiffener base, the first heat sink section, and/or the second heat sink section, and wherein the TIM accommodates a tolerance difference between the stiffener base, the first heat sink section, the second heat sink section, the processing unit, and/or the memory module.

10. The system of any of claims 4-9, further comprising:
a fluid inlet;
a fluid outlet;
an inlet tube that carries a cooling fluid between the fluid inlet and the first heat sink section; and
a flow channel contained within the first heat sink section, wherein the cooling fluid flows through the flow channel to extract the heat generated by the processing unit.

11. The system of any of claims 4-10, wherein the first heat sink section is liquid-cooled or air-cooled.

12. A system, comprising:
a first split heat sink assembly, comprising:
a first central heat sink that is liquid-cooled; and
at least one side wing heat sink that is thermally coupled with the first central heat sink; and
a second split heat sink assembly, comprising:
a second central heat sink that is liquid-cooled; and
at least one additional side wing heat sink that is thermally coupled with the second central heat sink.

13. The system of claim 12, wherein the first central heat sink is connected with the at least one side wing heat sink with at least a first screw, wherein the second central heat sink is connected with the at least one additional side wing heat sink with at least a second screw, wherein the at least one side wing heat sink is attachable to and detachable from the first central heat sink, and wherein the at least one additional side wing heat sink is attachable to and detachable from the second central heat sink.

14. The system of claim 13, wherein the first central heat sink is coupled with the second central heat sink by a coupling tube that carries a cooling fluid therebetween, wherein the at least one side wing heat sink is thermally coupled with the first central heat sink by at least a first heat pipe and wherein the at least one additional side wing heat sink is thermally coupled with the second central heat sink by at least a second heat pipe.

15. The system of claim 12, 13, or 14, wherein the first central heat sink extracts heat generated by a first high-power component, wherein the second central heat sink extracts heat generated by a second high-power component, wherein the at least one side wing heat sink extracts heat generated by a first low-power component, wherein the at least one additional side wing heat sink extracts heat generated by a second low-power component, and wherein a cooling fluid follows a flow path that causes the cooling fluid to encounter the first and second low-power components before encountering the first and second high-power components so as to avoid damaging the first and second low-power components with the heat generated by the first and second high-power components.
